(19) Europäisches Patentamt
European Patent Office
Office européen des brevets

(11) EP 0 380 720 B1

(12) EUROPEAN PATENT SPECIFICATION

(45) Date of publication and mention of the grant of the patent:
**12.08.1998 Bulletin 1998/33**

(51) Int Cl.[6]: **G06T 5/20**, H03H 17/02

(21) Application number: **89101564.6**

(22) Date of filing: **30.01.1989**

# (54) Image processing method

Verfahren zur Bildverarbeitung

Méthode de traitement d'image

(84) Designated Contracting States:
**BE DE FR GB GR IT NL SE**

(43) Date of publication of application:
**08.08.1990 Bulletin 1990/32**

(73) Proprietors:
- **YOZAN INC.**
  **Tokyo 155 (JP)**
- **SHARP KABUSHIKI KAISHA**
  **Osaka-shi, Osaka-fu 545 (JP)**

(72) Inventor: **Kumagai, Ryohei c/o Ezel Inc.**
**Shinjuku-ku Tokyo 160 (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**WO-A-87/07740**

- **PRIP78 - IEEE COMPUTER SOCIETY CONFERENCE ON PATTERN RECOGNITION AND IMAGE PROCESSING, Chicago, 31st May - 2nd June 1978, pages 137-141, IEEE, New York, US; P.M. NARENDRA: "A separable median filter for image noise smoothing"**
- **Idem**
- **IEEE INTERNATIONAL CONFERENCE ON ACOUSTICS, SPEECH, AND SIGNAL PROCESSING,**
- **ICASSP 84, San Diego, 19th-21st March 1984, vol. 2, pages 20.11.1-20.11.4, IEEE, New York, US; G.R. ARCE et al.: "Median filters analysis for 2 dimensional recursively filtered signals"**
- **COMMUNICATIONS OF THE ASSOCIATION OF COMPUTING MACHINERY, vol. 27, no. 8, August 1984, pages 807-818, New york, US; D.R.K. BROWNRIGG: "The weighted median filter"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 380 720 B1

Printed by Jouve, 75001 PARIS (FR)

## Description

### FIELD OF THE INVENTION

The present invention relates to an image processing method, particularly for smoothing without dulling edge.

### BACKGROUND OF THE INVENTION

For eliminating noises in an image, a local averaging method for smoothing is usually applied, because this method can be easily executed by a software of a local spatial calculation. In the resent large scale image processing system, an image is processed for the above smoothing in 32msec.

The local averaging method dulls edges of a configuration and make the image unclear as well as of low resolution. In order to solve this problem, various smoothing methods without dulling edge are proposed. Nagao method, local selecting method of pixels, hysteresis smoothing method, median filter method and E-filter method in frequency space. Among the above, median filter method is well known because of its high quality of the process result.

It is known from "IEEE Computer Society Conference on Pattern Recognition and Image Processing, Chicago, 31.5-2.6.1978, p. 137-141; P.W. Marenda : A separable median filter for image noise smoothing" to use a separable median filter which allocates to the center value of a window, the median of the precalculated row medians.

It is known from "IEEE international conference on acoustics, speech, and signal processing, 1984, San Diego , 19-21.3.1984, vol.2, p. 20.11.1-4, G.R. Arce et al. : Median filters analysis for 2 dimensional recursively filtered signals" to make the first grouping in a separable median filter vertically or alternatively horizontally.

A cross-shaped window, of dimension 3*3, for a median filter, is known from "Communications of the ACM, vol. 27, n°8, August 1984, p. 807-818, NY (US); D.R.K. Brownrigg : The weighted median filter".

However, the smoothing methods without dulling edge, including median filter method, need long process time and are difficult to be executed by a hardware. These methods cannot be applied to processes that is to be processed in high process speed.

### SUMMARY OF THE INVENTION

Therefore, the present invention has an object to provide an image processing method for smoothing without dulling edge.

The invention is set out in claim 1 of the appended claims.

### BRIEF DESCRIPTION OF THE DRAWINGS

Fig. 1 shows the first type grouping of the first embodiment of the present invention;
Fig. 2 shows the second type grouping of the embodiment;
Fig. 3 shows the third type grouping of the embodiment;
Fig. 4 shows the fourth type grouping of the embodiment;
Fig. 5 shows the fifth type grouping of the embodiment;
Fig. 6 shows dot patterns comparing the process result of the first grouping with the conventional median filter;
Fig. 7 shows dot patterns comparing the process result of the second grouping with the conventional median filter;
Fig. 8 shows a printer output for comparing process result of the first grouping with the conventional median filter;
Fig. 9 to 13 show other printer outputs;
Fig. 14 shows 3x3 convolution for describing the second embodiment;
Fig. 15 shows 5x5 convolution for describing the second embodiment;
Fig. 16 shows a dot pattern to be deleted by the second embodiment; and
Fig. 17 shows a dot pattern not to be deleted.

### PREFERRED EMBODIMENT OF THE PRESENT INVENTION

Exemplary preferred embodiments of the image processing method according to the present invention will be described in detail hereinafter.

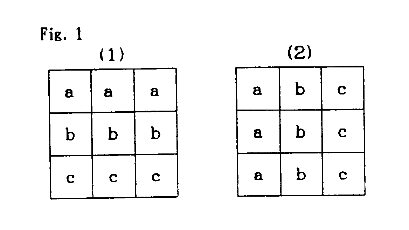

In Figs 1 (1) and (2), 3x3 convolutions to be read out are shown, in which references a, b, and c are given to pixels. These references represent groups for separating pixels. Each group includes 3 pixels vertically or horizontally aligned.

As for 3x3 convolution including 9 pixels, the number of combinations of grouping for generating 3 groups each of which include 3 pixels is calculated as follows;

$$ {}_9C_3 x {}_6C_3/3!=280 $$

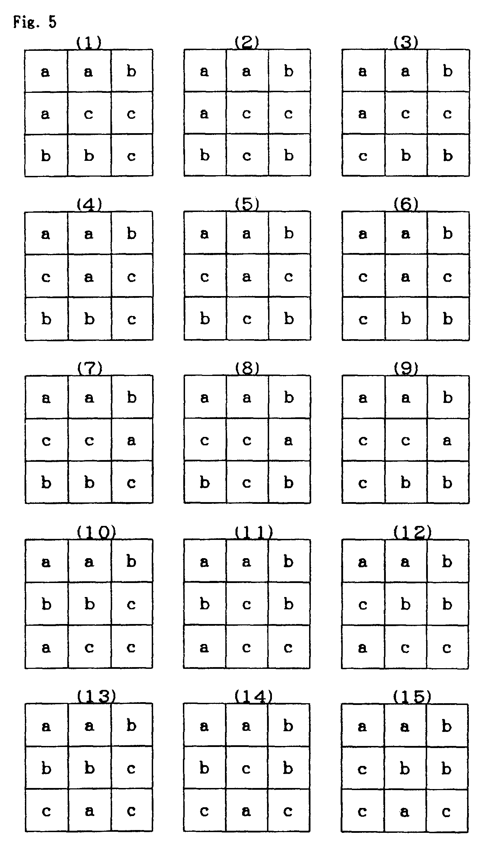

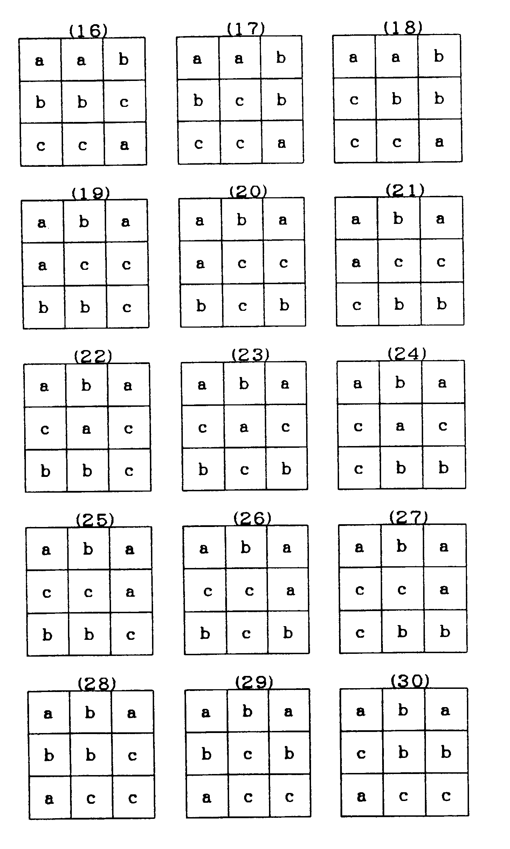

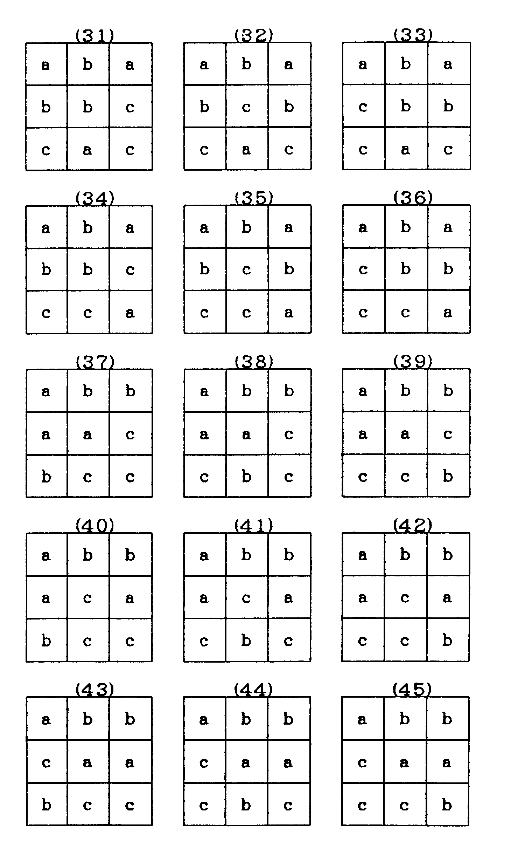

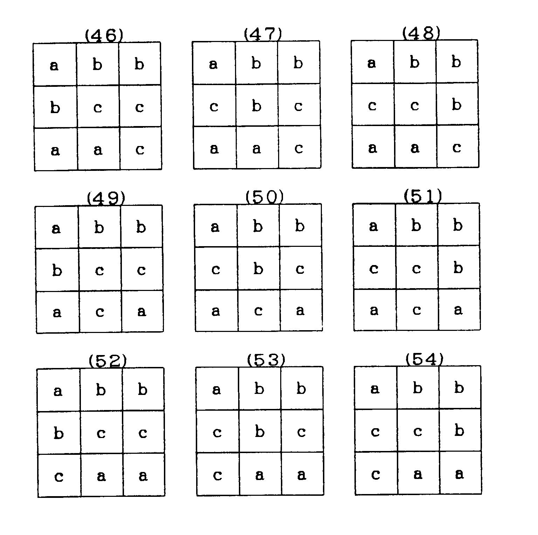

All types of groupings are shown in Figs 1 to 5. The grouping in Fig. 1 is the most simple type.

For each grouping, the smoothing without dulling edge is performed by the following calculation.

$$ Med\{Med\{a,a,a\}, Med\{b,b,b\}, Med\{c,c,c\}\} $$

where,

a : Density of each pixel in the group represented by the reference "a";
b : Density of each pixel in the group represented by the reference "b";
c : Density of each pixel in the group represented by the reference "c"; and
Med: Operator for extracting median value.

In this calculation, the total number N1 of sorting times is,

$$ N1=(1/2)n(n-1)^2 \qquad (2) $$

where, n is the number of groups as well as number of pixels in each group, "3" in this case.

While, the conventional median filter for nxn convolution needs the total number N2 of sorting times as follows;

$$ N2=(1/2)n^2(n^2-1) \qquad (3) $$

N1 is smaller than N2/n, so the process time of the first embodiment has much higher process speed than the conventional median filter. In the 3x3 convolution, the first embodiment has a process speed 6 times of that of the conventional median filter.

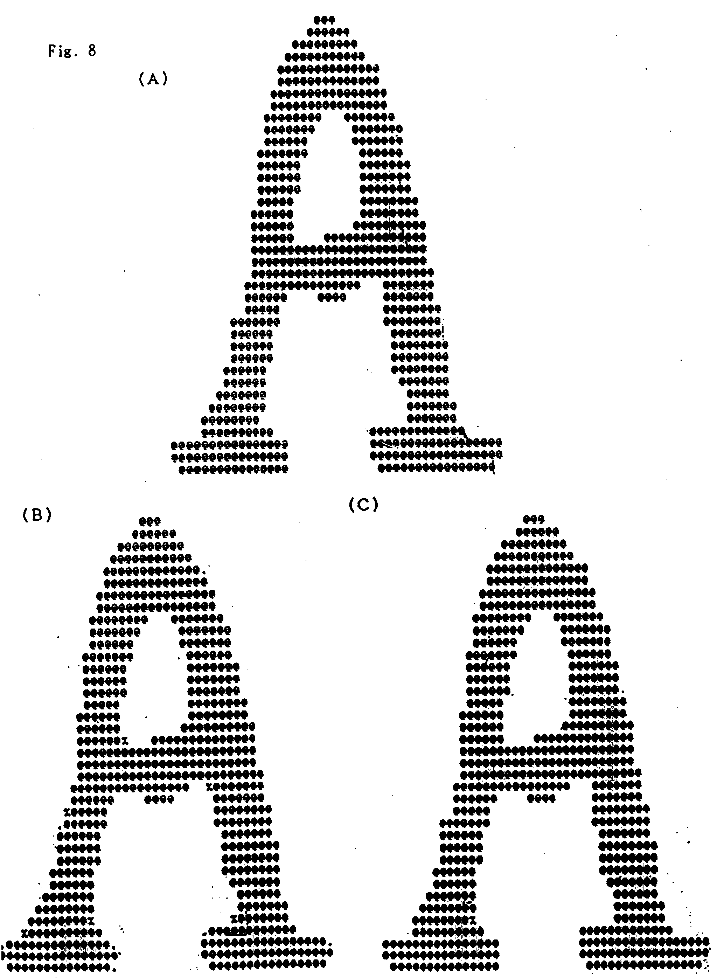

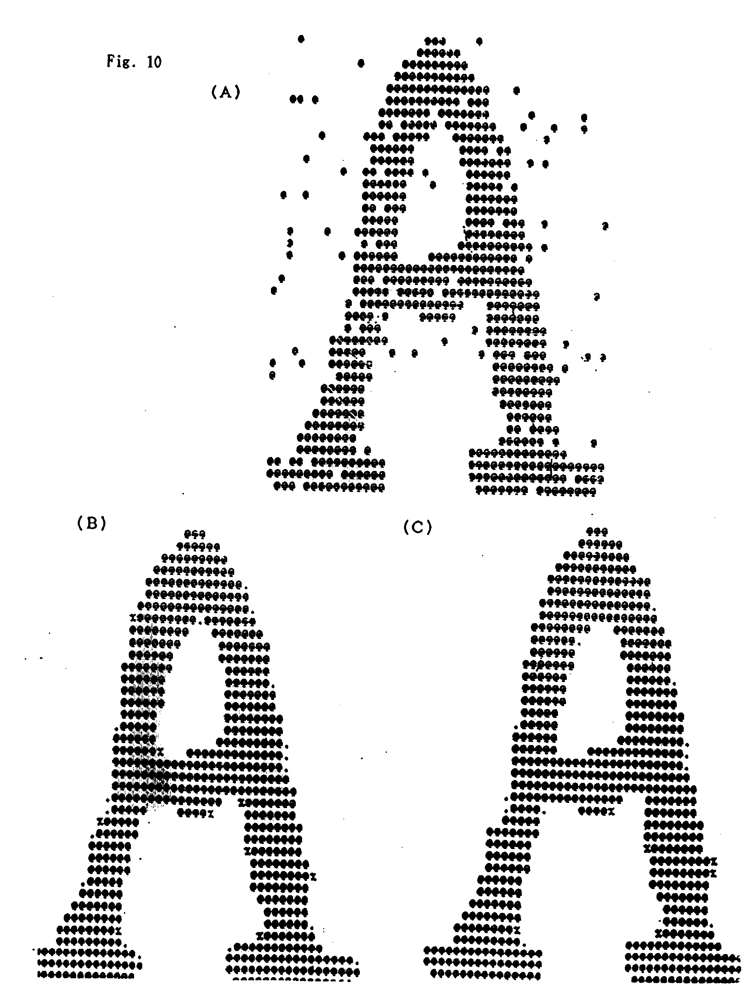

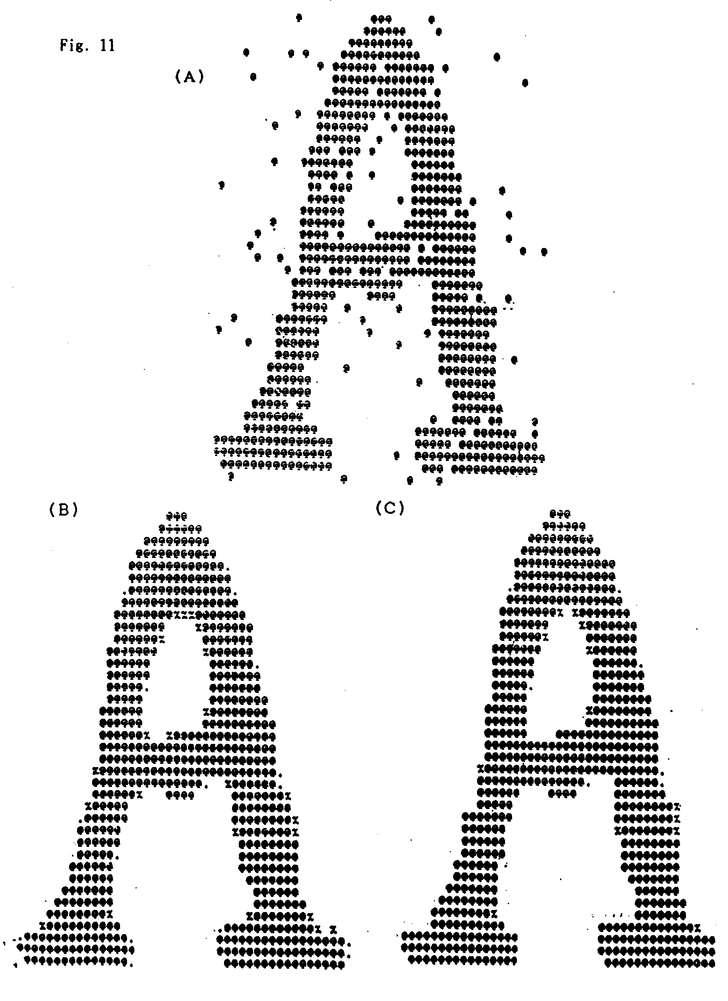

Figs 8 to 13 show printer outputs of a process result by the embodiment and by the conventional median filter.

Fig. 8 shows a process result for an image without noises.

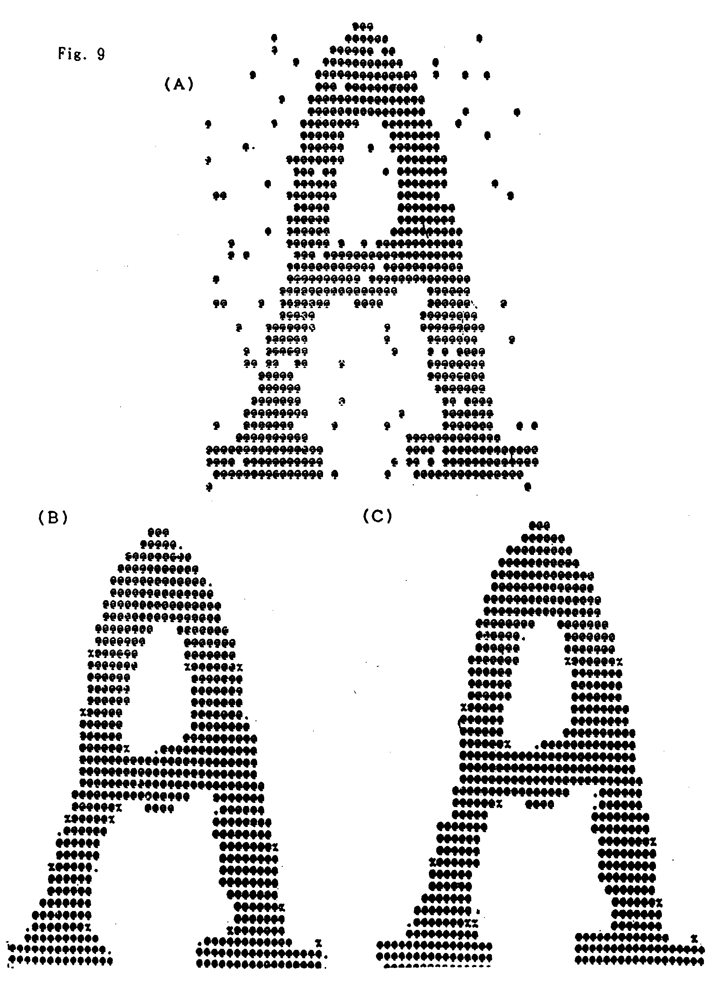

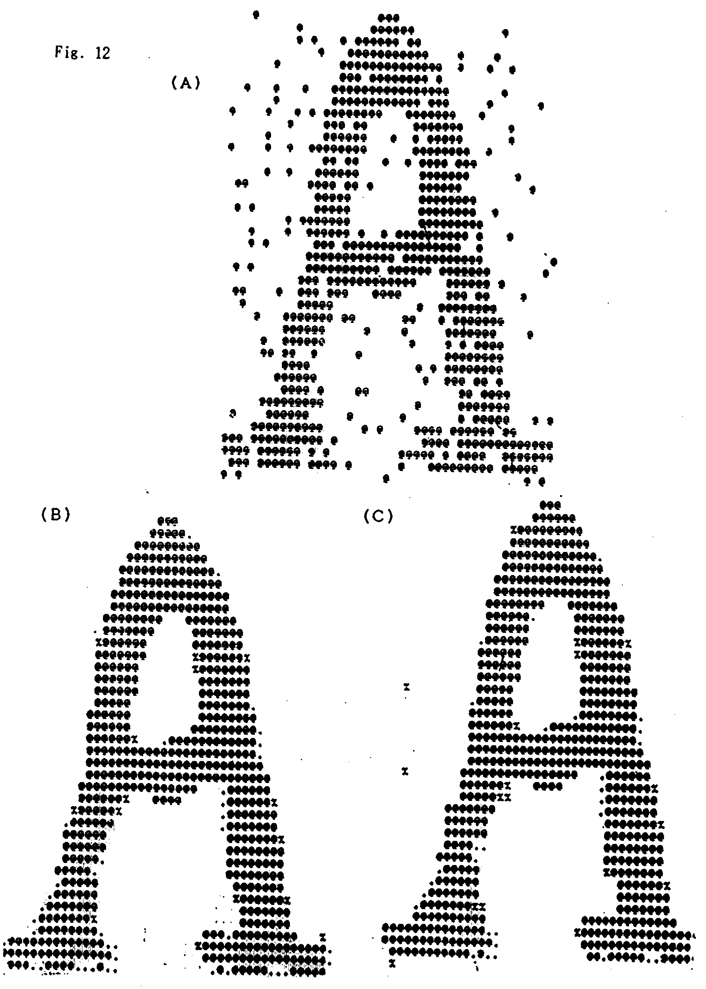

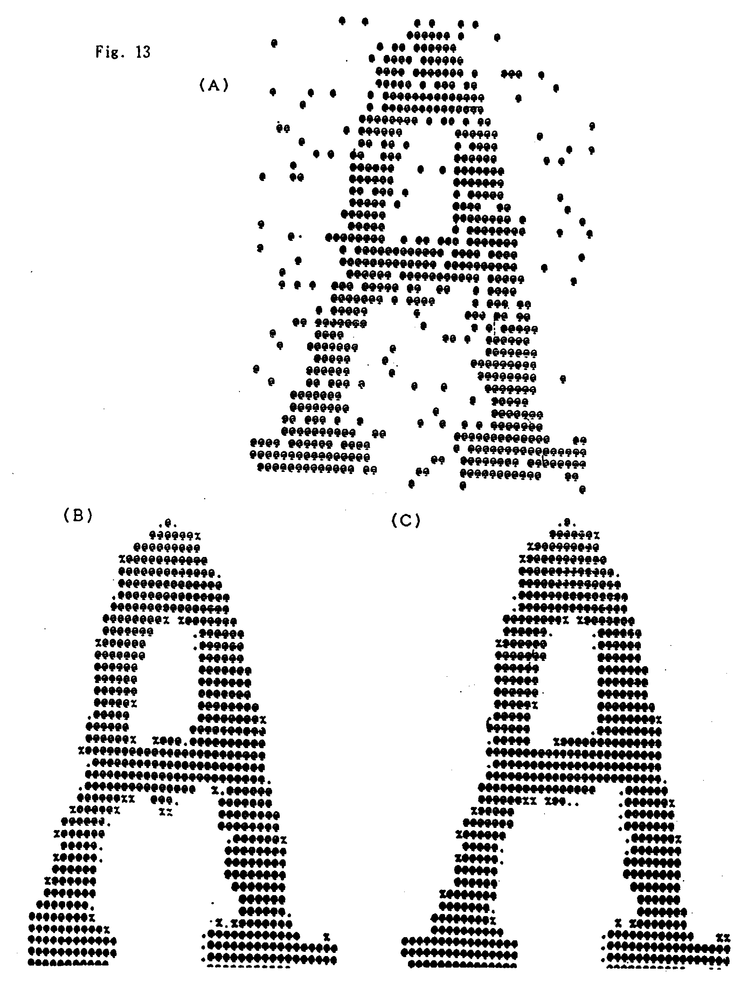

In Fig. 8, each dot is represented by "@", the original image is (A), the process result by the conventional median filter is (B) and the process result by the embodiment is (C). In the image (B) and (C), "%" represents a pixel generated by the processing but not included in the original image. The number of pixels in (B) is 13, while the number in (C) is 1. From the number, the processing of this embodiment is much better in the quality of the process result than the conventional median filter. A ratio of the number of correct, or not changed, pixels divided by total pixel number of original image without noises is an index for evaluating the quality of the process result. This ratio is now called "preservation ratio". The preservation ratio of the embodiment is 99.9%, while the ratio of the conventional median filter is 99.3%. The images to be processed (A) in Figs 9 to 11 include noises of 5%, the image to be processed (A) in Figs 12 and 13 include noises of 10%. In Table 1, the preservation ratio of the embodiment and the conventional median filter with respect to images (A) in Figs 8 to 13 are totally compared.

Table 1

| Image to be processed | Noise % | Process result of the embodiment | | Process result of the conventional median filter | |
|---|---|---|---|---|---|
| | | Error pixels | Preservation ratio(%) | Error pixels | Preservation ratio (%) |
| Fig. 8 | 0 | 1 | 99.9 | 13 | 99.3 |
| Fig. 9 | 5 | 18 | 99.0 | 30 | 98.2 |
| Fig. 10 | 5 | 18 | 99.0 | 28 | 98.4 |
| Fig. 11 | 5 | 22 | 98.7 | 39 | 97.8 |
| Fig. 12 | 10 | 50 | 97.1 | 54 | 96.9 |
| Fig. 13 | 10 | 53 | 97.0 | 53 | 97.0 |

The preservation ratio represents the elimination quality as well, because the preservation ratio is identical with the identification ratio of the processed image to the original image without noises.

The reason why the processing according to the present invention has high quality is that the processing evaluates pixels in more macro point of view than the conventional median filter.

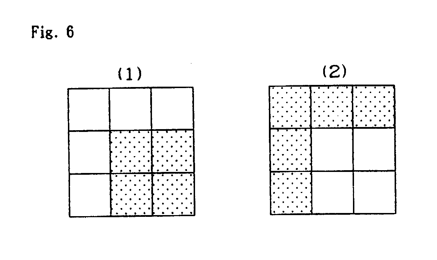

As for the dot pattern in Fig. 6 (1), the center pixel at the right angle convex corner is deleted in the conventional median filter. As for the dot pattern in Fig. 6 (2), a center pixel is added on the right angle concave corner in the conventional median filter. This is a problem of the conventional median filter in preserving the original image.

While in the processing of the first embodiment, the dot patterns in Figs 6 (1) and (2) are preserved as they are.

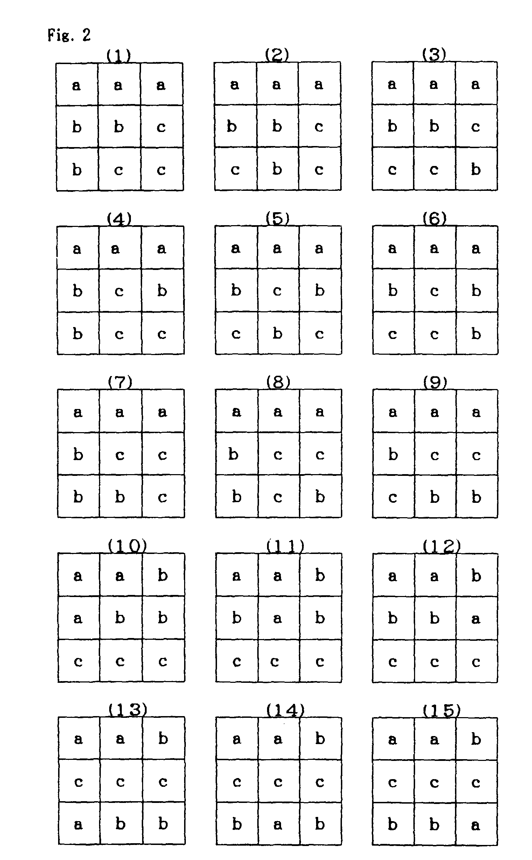

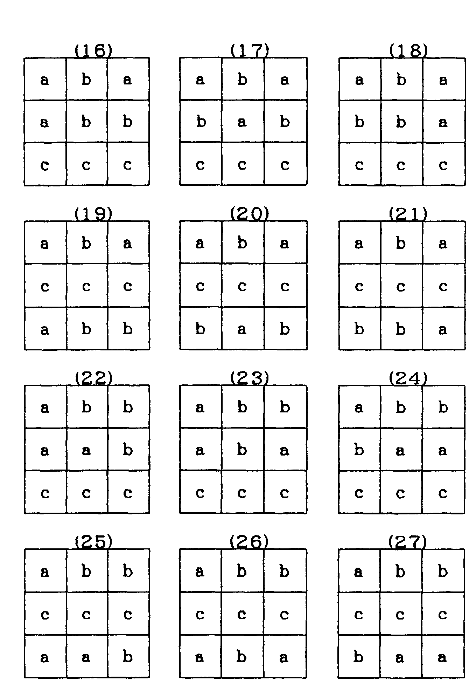

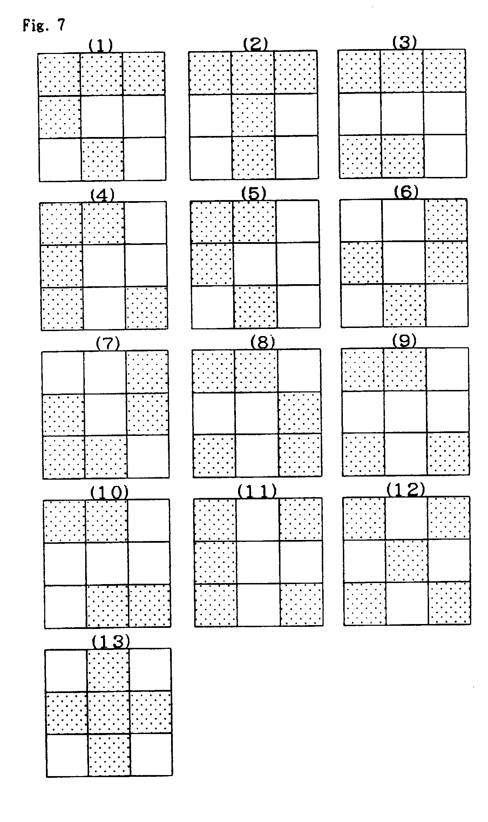

Fig. 2 shows the second grouping of the first embodiment. By this grouping, the process result is similar to that of the first grouping. In Figs 7 (1) to (3), dot patterns are shown, which are processed to be higher quality image by the second grouping than the first grouping. In Figs 7(4) to (13), there are shown patterns occasionally better in the process result of the second grouping than the first. The patterns rotationally or axially symmetric to the patterns in Figs 7 (4) to (13) are the same.

Figs 7 (1), (6) and (7) are patterns corresponding to an acute concavity with 45 degree. Such configuration is hardly exist in a natural image. The corner point in the concavity can be deemed to be a pixel accidentally deleted. The processing according to the second grouping can fill the corner point with a pixel of configuration's density.

Fig. 7 (2) shows a T-shaped pattern. The center pixel of the vertical line of the T-shape should not be deleted. In the reversed dot pattern, the corresponding pixel should not be filled with configuration's density. The processing according to the second grouping generates the process result of the T-shaped pattern meeting to the above requirement. The rotationally or axially symmetric patterns are processed the same.

Fig. 7 (3) shows a rotated and reversed L-shaped pattern. The center pixel of the vertical line of the T-shape should not be filled with configuration's density. In a not reversed pattern, the center pixel should not be deleted. In the conventional median filter, the center pixel in the reversed pattern is filled with configuration's density. While in the first embodiment according to the grouping of Figs 2 (1) to (7), (9) to (11), (15) to (17) and (20) to (23), the process result meets the above requirement.

Fig. 7 (4) shows a reversed steplike pattern. The pixel on the step corner is filled with configuration's density, in the processing according to the first grouping. While the processing according to the grouping in Figs 2 (12) to (14), (18) to (20), (24) and (26) processes the pattern so as not to fill the pixel on the step corner. The not reversed pattern, rotational symmetric pattern of reversed or not reversed pattern, and axially symmetric pattern of reversed or not reversed pattern are adequately processed by the grouping above, as well.

Fig. 7 (5) to (7) show a low trapezoid line pattern. The pixel inside of the trapezoid should be filled with configuration's density. In the reversed pattern, the inside of the trapezoid should be deleted. In the conventional median filter, or in the processing according to the first grouping, the inside pixel is kept as it is. According to the second grouping, the inside pixel is changed, meeting to the above requirement. The reversed pattern, the rotationally symmetric pattern of the reversed or not reversed pattern, and the axially symmetric pattern of the reversed or not reversed pattern are adequately processed, as well.

Fig. 7 (8) shows a reversed Y-shaped pattern. The cross point of Y-shape should not be filled with configuration's density. However, the conventional median filter and the processing according to the first grouping fill the above cross point. While, the processing according the the second grouping keeps the cross point as it is.

Fig. 7 (9) shows a rotated and reversed short foot L-shaped pattern with an additional dot. The center pixel of the vertical line of the L-shape should not be filled with configuration's density. However, in the processing according to the first grouping, the center pixel is filled with configuration's density. While, according to the second grouping, the center pixel is not filled.

Fig. 7 (10) shows a reversed high step-like pattern. The middle pixel of the step should not be filled with configuration's density. However, according to the first grouping, the middle pixel is filled. While, according to the second grouping, the middle pixel is not filled.

Fig. 7 (11) shows a rotated and reversed low T-shaped pattern. The center pixel of the horizontal line of T-shape should not be filled with configuration's density. However, according to the first grouping, the center pixel is filled. While, according to the second grouping the center pixel is not filled.

The reverse pattern of Figs 7 (8) to (11), a rotationally symmetric pattern of reversed or non reversed pattern, and axially symmetric pattern of reversed or not reversed pattern are processed adequately according to the second grouping, as well.

Fig. 7 (12) shows a reversed box with one dot hole. The center pixel corresponding to the hole should be deleted so as to make the box holeless. However, the conventional median filter and the processing according to the first grouping keep the center pixel as it is. While, according to the second grouping of Figs 2 (14), (15), (19), (21), (26) and (27), the center pixel is deleted. The reversed pattern of the pattern in Fig. 7 (12), rotationally symmetric pattern of reversed or not reversed pattern and axially symmetric pattern of reversed or not reversed pattern are adequately processed, as well.

Fig. 7 (13) shows a crossing pattern. The center pixel of the crossing should not be deleted. However, the center pixel is deleted, according to the first grouping. While the center pixel is not deleted according to the grouping in Figs 2(1), (3), (4), (6), (7), (9) to (12), (14), (19), (21) to (24) and (26).

The second grouping has process results 88% similar to that of the first grouping. Particularly the grouping in Figs 2 (2), (4), (5), (8), (13), (15), (17), (18), (20), (25) and (27) include a lot of better process results than that of the first grouping.

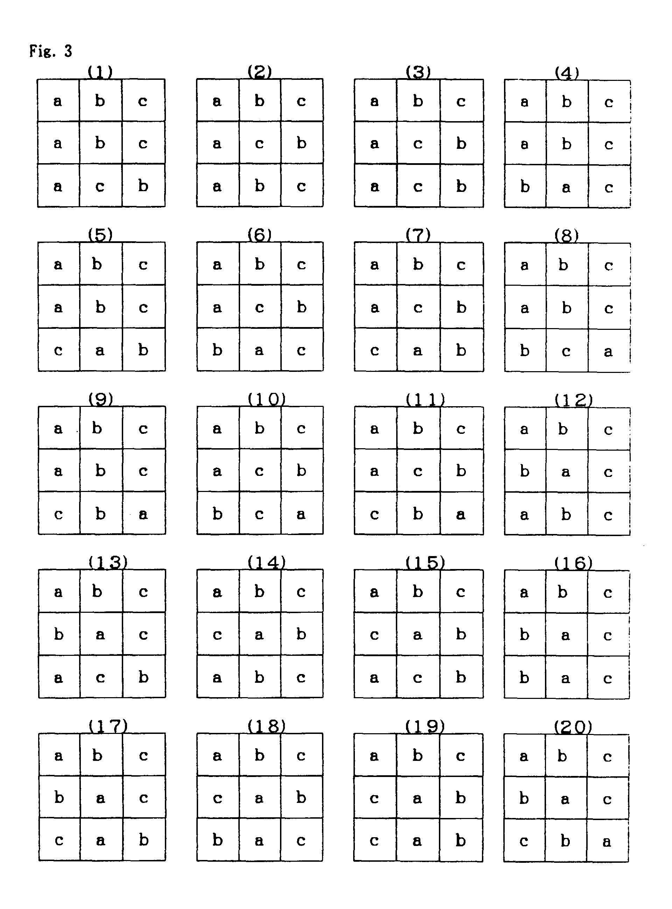

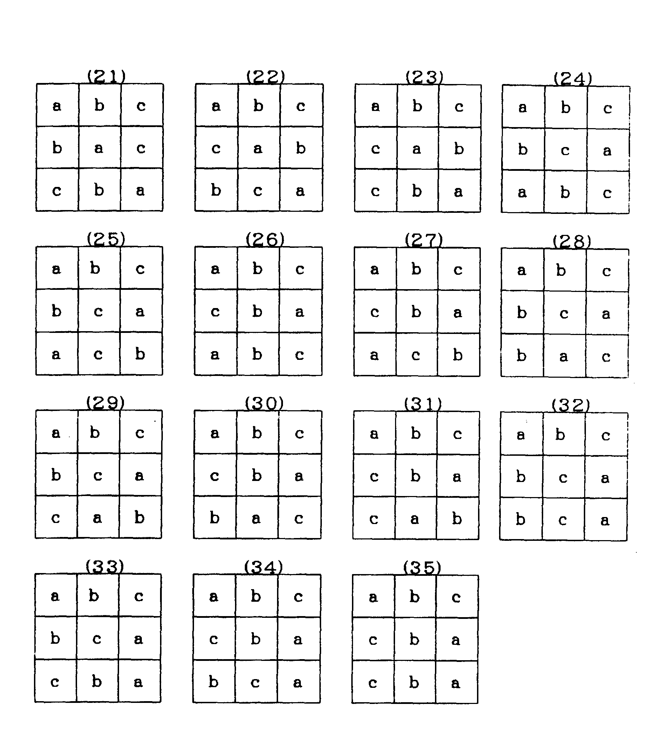

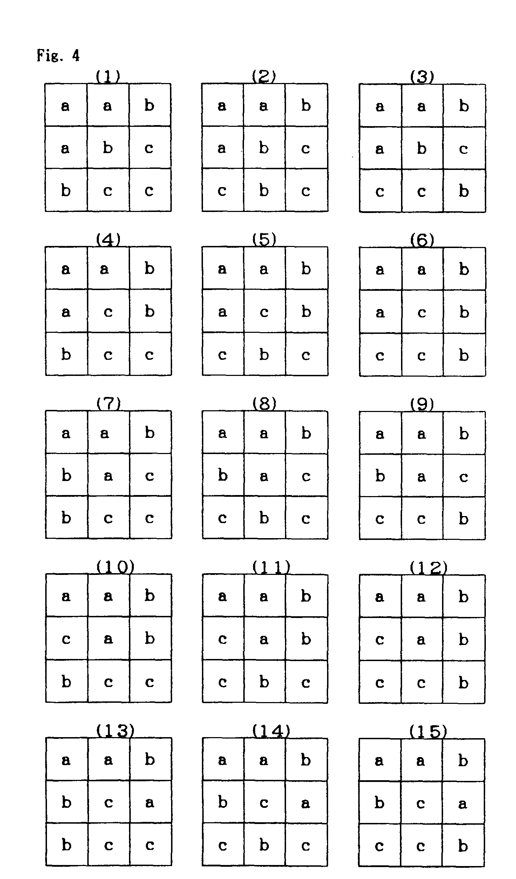

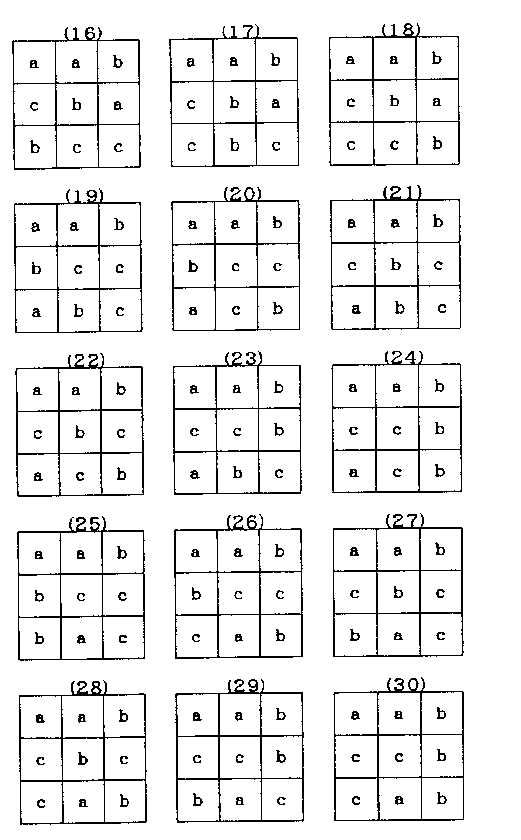

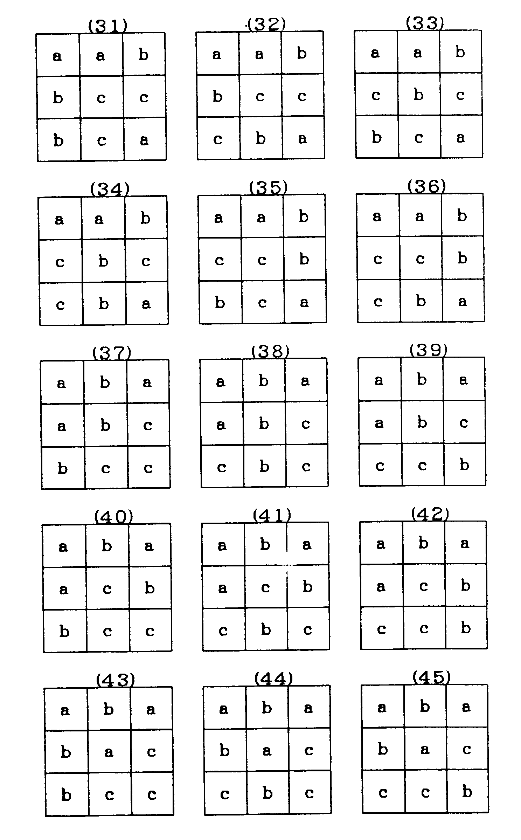

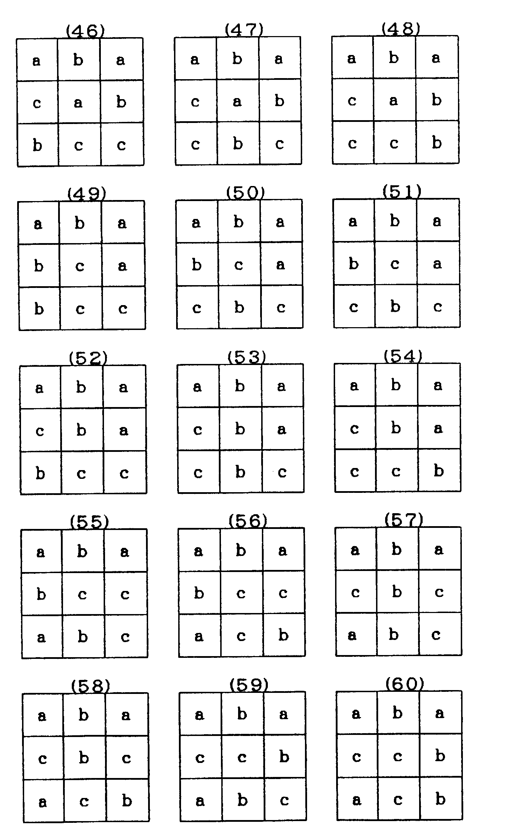

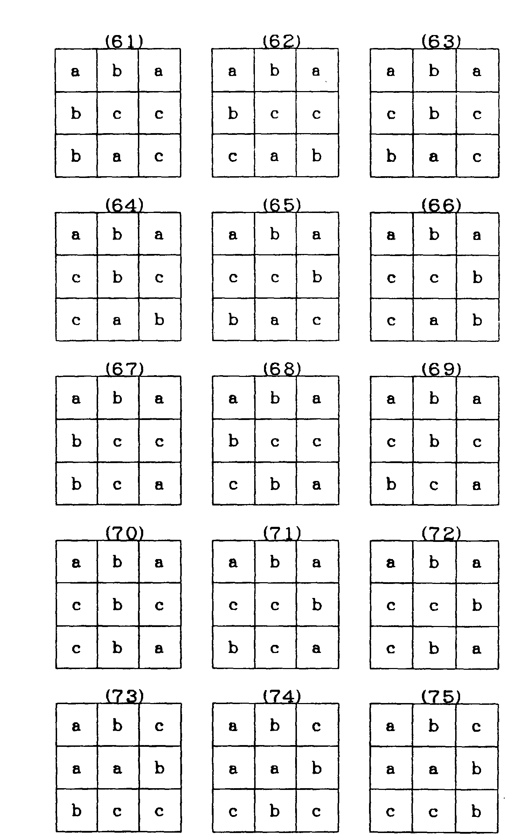

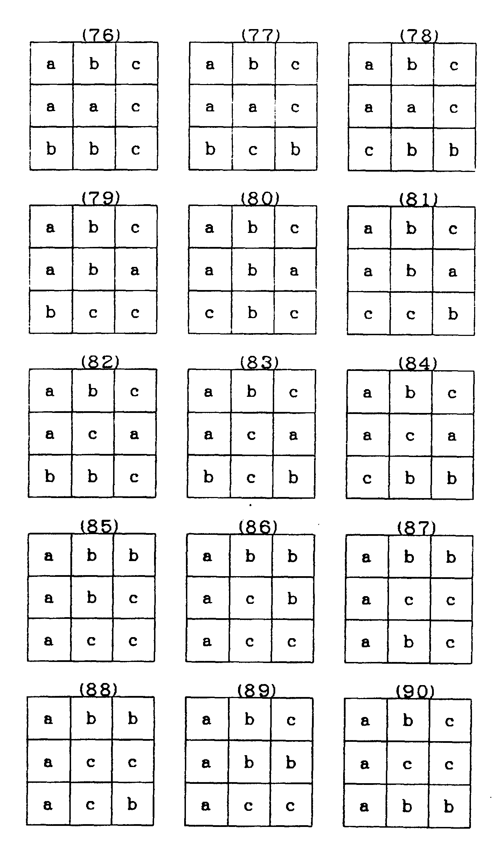

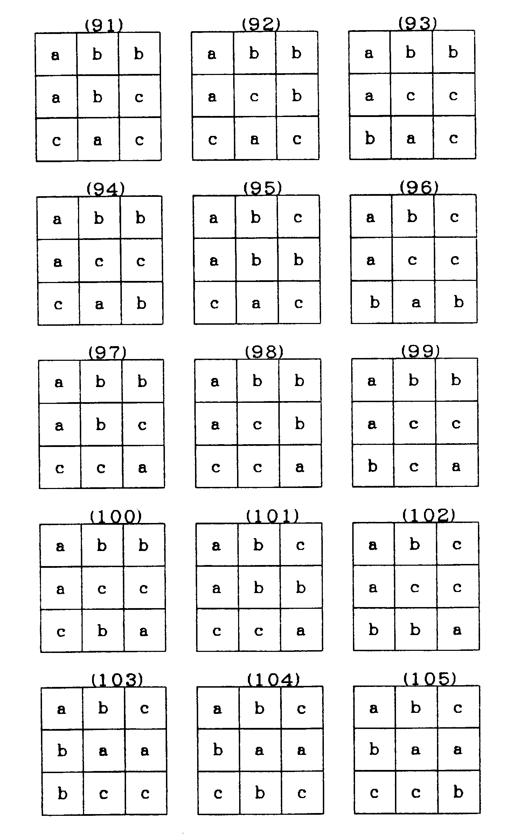

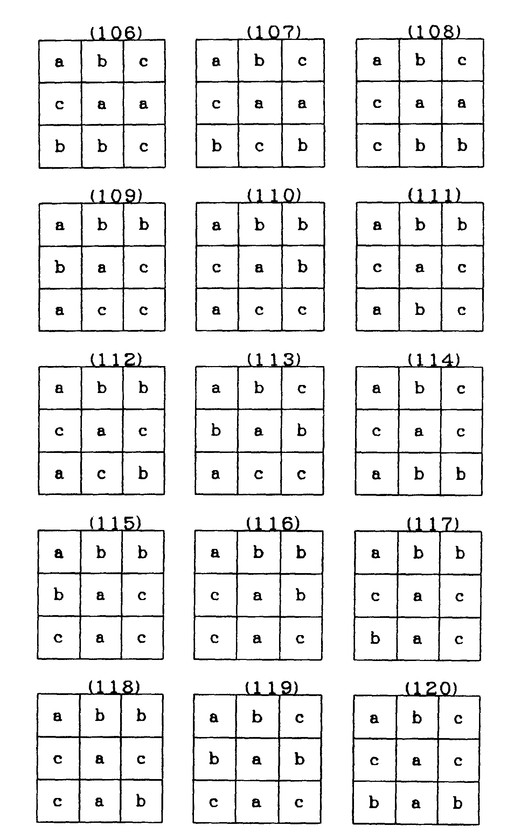

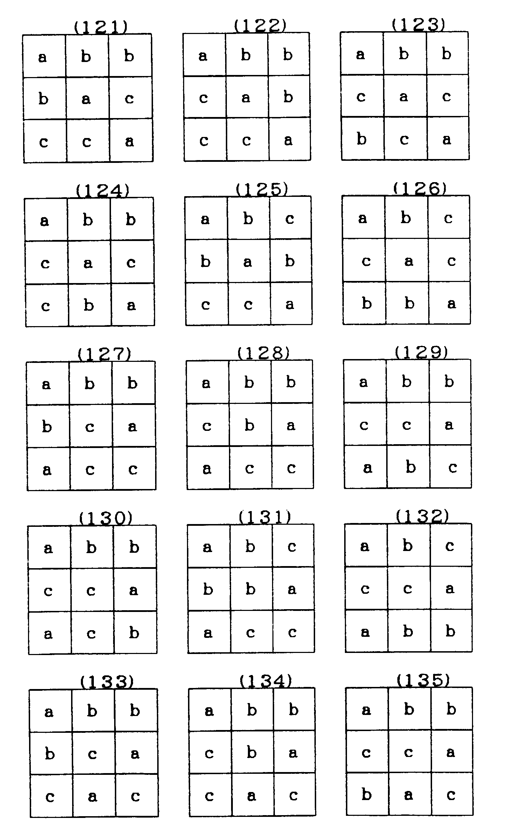

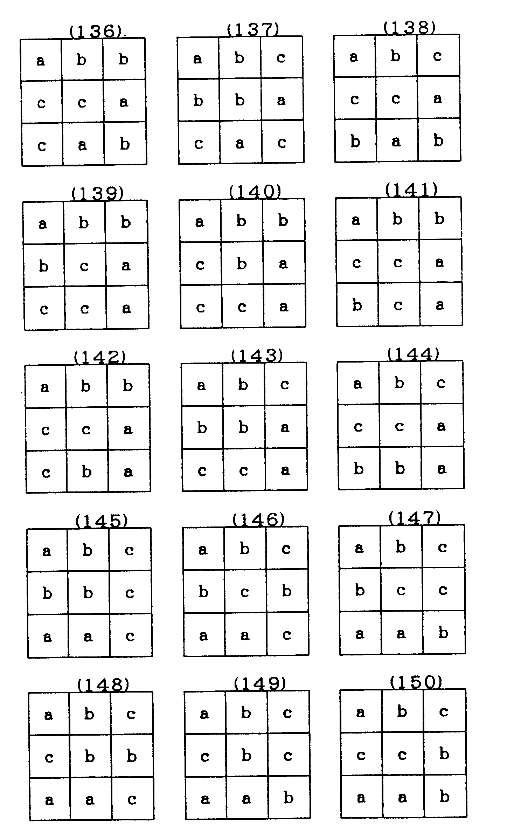

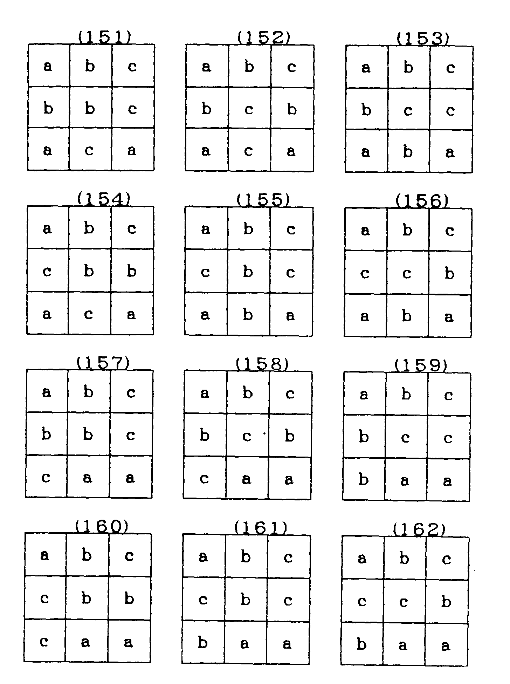

The process result of the third grouping (Fig. 3), the fourth grouping (Fig. 4) and the fifth grouping are identical in 86% pattern, 83% pattern and 81% pattern, respectively, with the process result of the first grouping whose high quality has already proved.

Furthermore, the second to the fifth grouping have process result 90% identical with the conventional median filter.

Hereinafter, the second embodiment is described in detail.

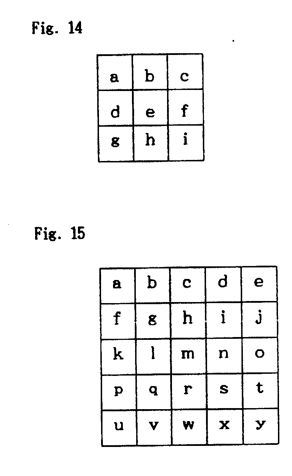

In Fig. 14, a 3x3 convolution is shown with references a to i in the order along the scan line.

The following calculation is performed in the second embodiment.

$$\mathrm{Med}\{d, \mathrm{Med}\{b, e, h\}, f\} \tag{2}$$

or

$$\mathrm{Med}\{b, \mathrm{Med}\{d, e, f\}, h\} \tag{3}$$

where,

b, d, e, f, h: Density of the pixels designated by these references.

The median calculation in the above formula (2) is simplified as follows;

$$\mathrm{Med}\{b, e, h\} = \mathrm{Max}\{\mathrm{Min}\{b, e\}, \mathrm{Min}\{e, h\}, \mathrm{Min}\{h, b\}\} \tag{4}$$

or

$$\mathrm{Med}\{b, e, h\} = \mathrm{Min}\{\mathrm{Max}\{b, e\}, \mathrm{Max}\{e, h\}, \mathrm{Max}\{h, b\}\} \tag{5}$$

The above calculations (2) and (3) mean a median calculation of a horizontal and vertical crossing pattern. This calculation is much simpler and takes much shorter calculation time than the first embodiment.

When the center pixel of the convolution is positioned on the cross point of the crossing, the calculation represents the total characteristics of the convolution.

The crossing may be changed to be oblique crossing. The calculation for oblique crossing is as follows;

$$\mathrm{Med}\{a, \mathrm{Med}\{c, e, g\}, i\} \tag{6}$$

or

$$\mathrm{Med}\{c, \mathrm{Med}\{a, e, i\}, g\} \tag{7}$$

Fig. 15 shows a 5x5 convolution in which references a to y in the order along the scan line are given.

The crossing pattern median calculation can be applied to the 5x5 convolution, as well. The calculation is performed as follows;

$$Med\{k, l, Med\{c, h, m, r, w\}, n, o\} \quad (8)$$

or

$$Med\{c, h, Med\{k, l, m, n, o\}, r, w\} \quad (9)$$

or

$$Med\{e, i, Med\{a, g, m, s, y\}, q, u\} \quad (10)$$

or

$$Med\{a, g, Med\{e, i, m, q, u\}, s, y\} \quad (11)$$

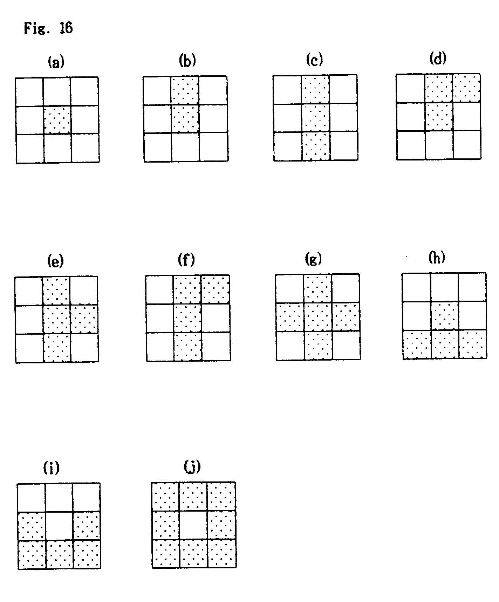

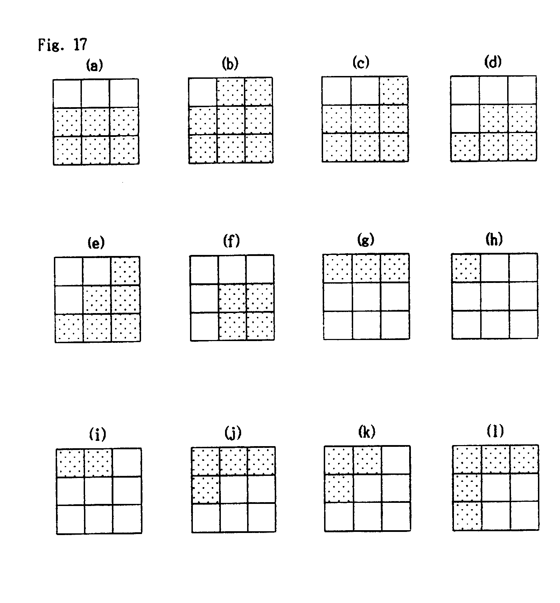

Table 2 shows the process result of the formula (2), (3), (6), (7) and the conventional median filter, with respect to the pattern in Figs 16 (a) to (j) and Figs 17 (a) to (l).

Table 2

| Pattern | | Formula (2) | Formula (3) | Formula (6) | Formula (7) | Conventional Median Filter |
|---|---|---|---|---|---|---|
| Fig.16 | (a) | 0 | 0 | 0 | 0 | 0 |
| | (b) | 0 | 0 | 0 | 0 | 0 |
| | (c) | 0 | 1 | 0 | 0 | 0 |
| | (d) | 0 | 0 | 0 | 0 | 0 |
| | (e) | 1 | 1 | 0 | 0 | 0 |
| | (f) | 0 | 1 | 0 | 0 | 0 |
| | (g) | 1 | 1 | 0 | 0 | 1 |
| | (h) | 0 | 0 | 1 | 1 | 0 |
| | (i) | 1 | 1 | 0 | 0 | 1 |
| | (j) | 1 | 1 | 1 | 1 | 1 |
| Fig.17 | (a) | 1 | 1 | 1 | 1 | 1 |
| | (b) | 1 | 1 | 1 | 1 | 1 |
| | (c) | 1 | 1 | 1 | 1 | 1 |
| | (d) | 1 | 1 | 1 | 1 | 1 |
| | (e) | 1 | 1 | 1 | 1 | 1 |
| | (f) | 1 | 1 | 0 | 0 | 0 |
| | (g) | 0 | 0 | 0 | 0 | 0 |
| | (h) | 0 | 0 | 0 | 0 | 0 |
| | (i) | 0 | 0 | 0 | 0 | 0 |
| | (j) | 0 | 0 | 0 | 0 | 0 |
| | (k) | 0 | 0 | 0 | 0 | 0 |
| | (l) | 0 | 0 | 1 | 1 | 1 |

The patterns in Fig. 16 are processed by the formula (2), (3), (6) and (7) similar to the conventional median filter. With respect to the patterns in Fig. 17, the calculation results of the formulas have advantages that one-dot lines crossing the convolution are usually preserved.

## Claims

1. Image processing method for smoothing a configuration comprised of pixels without thereby dulling edges of the configuration, comprising the steps of:

   calculating for each pixel of the configuration a median value from pixel-values contained in a n x n-calculation window centered on the respective pixel characterised in that said calculating comprises the steps of:

   first calculating the median value of pixels arranged on a first line crossing the center of the window, and second calculating the final median value by calculating the median value of the value obtained by the first calculation and values of pixels arranged on a line which is substantially orthogonal to the first line, wherein the median value of the first calculation is obtained by calculating minimum values of all three different pixel pairs of the first line and determining the maximum value therefrom.

2. Image processing method for smoothing a configuration comprised of pixels without thereby dulling edges of the configuration, comprising the steps of:

   calculating for each pixel of the configuration a median value from pixel-values contained in a n x n-calculation window centered on the respective pixel characterised by said calculating comprises the steps of:

   first calculating the median value of pixels arranged on a first line crossing the center of the window, and second calculating the final median value by calculating the median value of the value obtained by the first calculation and values of pixels arranged on a line which is substantially orthogonal to the first line, wherein the median value of the first calculation is obtained by calculating the maximum values of all three different pixel pairs of the first line and determining therefrom the minimum value.

3. Image processing method according to claim 1 or 2 wherein said calculation window is a 5 x 5-window.

4. Image processing method according to claim 1 or 2 wherein said calculation window is a 3 x 3-window.

## Patentansprüche

1. Bildverarbeitungsverfahren zum Glätten einer Konfiguration, die aus Pixeln besteht, ohne dabei die Ränder der Konfiguration abzustumpfen , mit den Schritten:

   Berechnen eines Mittelwertes für jedes Pixel in der Konfiguration aus Pixelwerten, welche in einem n x n-Berechnungsfenster, welches über dem jeweiligen Pixel zentriert ist, enthalten sind, **dadurch gekennzeichnet,** daß die Berechnung die Schritte umfaßt:

   erstens Berechnen des Mittelwertes derjenigen Pixel, welche auf einer ersten Linie angeordnet sind, die die Mitte des Fensters kreuzt, und

   zweitens Berechnen des endgültigen Mittelwertes durch Berechnen des Mittelwertes aus dem Wert, der durch die erste Berechnung erhalten wurde und aus denjenigen Werten von Pixeln, welche auf einer Linie angeordnet sind, die im wesentlichen rechtwinklig zu der ersten Linie verläuft, wobei der Mittelwert der ersten Berechnung erhalten wird durch Berechnen der Minimalwerte aller drei unterschiedlichen Pixelpaare der ersten Linie und Bestimmen der Maximalwerte davon.

2. Bildverarbeitungsverfahren zum Glätten einer Konfiguration, welche aus Pixeln besteht, ohne dabei die Ränder der Konfiguration zu ermatten, mit den Schritten:

   Berechnen eines Mittelwertes für jedes Pixel der Konfiguration aus Pixelwerten, welche in einem n x n-Berechnungsfenster enthalten sind, das über dem jeweiligen Pixel zentriert ist, **dadurch gekennzeichnet,** daß die Berechnung die Schritte umfaßt: erstens Berechnen des Mittelwertes derjenigen Pixel, die auf einer ersten Linie angeordnet sind, die die Mitte des Fensters kreuzt, und

zweitens Berechnen des endgültigen Mittelwertes durch Berechnen des Mittelwertes aus dem Wert, der aus der ersten Berechnung erhalten wurde und aus Werten von Pixeln, welche auf einer Linie angeordnet sind, die im wesentlichen rechtwinklig zu der ersten Linie verläuft, wobei der Mittelwert der ersten Berechnung erhalten wird, durch Berechnen der Maximalwerte aller drei unterschiedlichen Pixelpaare auf der ersten Linie und Bestimmen des Minimalwertes davon.

**3.** Bildverarbeitungsverfahren nach Anspruch 1 oder 2, **dadurch gekennzeichnet,** daß das Berechnungsfenster ein 5x5-Fenster ist.

**4.** Bildverarbeitungsverfahren nach Anspruch 1 oder 2, **dadurch gekennzeichnet,** daß das Berechnungsfenster ein 3x3-Fenster ist.

**Revendications**

**1.** Procédé de traitement d'image pour lisser une configuration constituée de pixels de façon à ne pas émousser les bords de la configuration, comprenant les étapes consistant à :

calculer pour chaque pixel de la configuration une valeur médiane d'après les valeurs de pixels contenus dans une fenêtre de calcul de n x n, centrée sur le pixel respectif, caractérisé en ce que ledit calcul comprend les étapes consistant à :
premièrement, calculer la valeur médiane des pixels agencés sur une première ligne coupant le centre de la fenêtre et deuxièmement, calculer la valeur médiane finale en calculant la valeur médiane de la valeur obtenue par le premier calcul et des valeurs de pixels agencés sur une ligne qui est sensiblement orthogonale à la première ligne, dans lequel la valeur médiane du premier calcul est obtenue en calculant les valeurs minimales de l'ensemble des trois paires de pixels différentes de la première ligne et en déterminant de là la valeur maximale.

**2.** Procédé de traitement d'image pour lisser une configuration constituée de pixels de façon à ne pas émousser les bords de la configuration, comprenant les étapes consistant à :

calculer pour chaque pixel de la configuration une valeur médiane d'après les valeurs de pixels contenus dans une fenêtre de calcul de n x n, centrée sur le pixel respectif, caractérisé en ce que ledit calcul comprend les étapes consistant à :
premièrement, calculer la valeur médiane des pixels agencés sur une première ligne coupant le centre de la fenêtre et deuxièmement, calculer la valeur médiane finale en calculant la valeur médiane de la valeur obtenue par le premier calcul et des valeurs de pixels agencés sur une ligne qui est sensiblement orthogonale à la première ligne, dans lequel la valeur médiane du premier calcul est obtenue en calculant les valeurs maximales de l'ensemble des trois paires de pixels différentes de la première ligne et en déterminant de là la valeur minimale.

**3.** Procédé de traitement d'image selon la revendication 1 ou 2, dans lequel ladite fenêtre de calcul est une fenêtre de 5 x 5.

**4.** Procédé de traitement d'image selon la revendication 1 ou 2, dans lequel ladite fenêtre de calcul est une fenêtre de 3 x 3.

Fig. 1

(1)

| | | |
|---|---|---|
| a | a | a |
| b | b | b |
| c | c | c |

(2)

| | | |
|---|---|---|
| a | b | c |
| a | b | c |
| a | b | c |

Fig. 2

(1)

| | | |
|---|---|---|
| a | a | a |
| b | b | c |
| b | c | c |

(2)

| | | |
|---|---|---|
| a | a | a |
| b | b | c |
| c | b | c |

(3)

| | | |
|---|---|---|
| a | a | a |
| b | b | c |
| c | c | b |

(4)

| | | |
|---|---|---|
| a | a | a |
| b | c | b |
| b | c | c |

(5)

| | | |
|---|---|---|
| a | a | a |
| b | c | b |
| c | b | c |

(6)

| | | |
|---|---|---|
| a | a | a |
| b | c | b |
| c | c | b |

(7)

| | | |
|---|---|---|
| a | a | a |
| b | c | c |
| b | b | c |

(8)

| | | |
|---|---|---|
| a | a | a |
| b | c | c |
| b | c | b |

(9)

| | | |
|---|---|---|
| a | a | a |
| b | c | c |
| c | b | b |

(10)

| | | |
|---|---|---|
| a | a | b |
| a | b | b |
| c | c | c |

(11)

| | | |
|---|---|---|
| a | a | b |
| b | a | b |
| c | c | c |

(12)

| | | |
|---|---|---|
| a | a | b |
| b | b | a |
| c | c | c |

(13)

| | | |
|---|---|---|
| a | a | b |
| c | c | c |
| a | b | b |

(14)

| | | |
|---|---|---|
| a | a | b |
| c | c | c |
| b | a | b |

(15)

| | | |
|---|---|---|
| a | a | b |
| c | c | c |
| b | b | a |

(16)

| | | |
|---|---|---|
| a | b | a |
| a | b | b |
| c | c | c |

(17)

| | | |
|---|---|---|
| a | b | a |
| b | a | b |
| c | c | c |

(18)

| | | |
|---|---|---|
| a | b | a |
| b | b | a |
| c | c | c |

(19)

| | | |
|---|---|---|
| a | b | a |
| c | c | c |
| a | b | b |

(20)

| | | |
|---|---|---|
| a | b | a |
| c | c | c |
| b | a | b |

(21)

| | | |
|---|---|---|
| a | b | a |
| c | c | c |
| b | b | a |

(22)

| | | |
|---|---|---|
| a | b | b |
| a | a | b |
| c | c | c |

(23)

| | | |
|---|---|---|
| a | b | b |
| a | b | a |
| c | c | c |

(24)

| | | |
|---|---|---|
| a | b | b |
| b | a | a |
| c | c | c |

(25)

| | | |
|---|---|---|
| a | b | b |
| c | c | c |
| a | a | b |

(26)

| | | |
|---|---|---|
| a | b | b |
| c | c | c |
| a | b | a |

(27)

| | | |
|---|---|---|
| a | b | b |
| c | c | c |
| b | a | a |

Fig. 3

(1)

| | | |
|---|---|---|
| a | b | c |
| a | b | c |
| a | c | b |

(2)

| | | |
|---|---|---|
| a | b | c |
| a | c | b |
| a | b | c |

(3)

| | | |
|---|---|---|
| a | b | c |
| a | c | b |
| a | c | b |

(4)

| | | |
|---|---|---|
| a | b | c |
| a | b | c |
| b | a | c |

(5)

| | | |
|---|---|---|
| a | b | c |
| a | b | c |
| c | a | b |

(6)

| | | |
|---|---|---|
| a | b | c |
| a | c | b |
| b | a | c |

(7)

| | | |
|---|---|---|
| a | b | c |
| a | c | b |
| c | a | b |

(8)

| | | |
|---|---|---|
| a | b | c |
| a | b | c |
| b | c | a |

(9)

| | | |
|---|---|---|
| a | b | c |
| a | b | c |
| c | b | a |

(10)

| | | |
|---|---|---|
| a | b | c |
| a | c | b |
| b | c | a |

(11)

| | | |
|---|---|---|
| a | b | c |
| a | c | b |
| c | b | a |

(12)

| | | |
|---|---|---|
| a | b | c |
| b | a | c |
| a | b | c |

(13)

| | | |
|---|---|---|
| a | b | c |
| b | a | c |
| a | c | b |

(14)

| | | |
|---|---|---|
| a | b | c |
| c | a | b |
| a | b | c |

(15)

| | | |
|---|---|---|
| a | b | c |
| c | a | b |
| a | c | b |

(16)

| | | |
|---|---|---|
| a | b | c |
| b | a | c |
| b | a | c |

(17)

| | | |
|---|---|---|
| a | b | c |
| b | a | c |
| c | a | b |

(18)

| | | |
|---|---|---|
| a | b | c |
| c | a | b |
| b | a | c |

(19)

| | | |
|---|---|---|
| a | b | c |
| c | a | b |
| c | a | b |

(20)

| | | |
|---|---|---|
| a | b | c |
| b | a | c |
| c | b | a |

(21)

| | | |
|---|---|---|
| a | b | c |
| b | a | c |
| c | b | a |

(22)

| | | |
|---|---|---|
| a | b | c |
| c | a | b |
| b | c | a |

(23)

| | | |
|---|---|---|
| a | b | c |
| c | a | b |
| c | b | a |

(24)

| | | |
|---|---|---|
| a | b | c |
| b | c | a |
| a | b | c |

(25)

| | | |
|---|---|---|
| a | b | c |
| b | c | a |
| a | c | b |

(26)

| | | |
|---|---|---|
| a | b | c |
| c | b | a |
| a | b | c |

(27)

| | | |
|---|---|---|
| a | b | c |
| c | b | a |
| a | c | b |

(28)

| | | |
|---|---|---|
| a | b | c |
| b | c | a |
| b | a | c |

(29)

| | | |
|---|---|---|
| a | b | c |
| b | c | a |
| c | a | b |

(30)

| | | |
|---|---|---|
| a | b | c |
| c | b | a |
| b | a | c |

(31)

| | | |
|---|---|---|
| a | b | c |
| c | b | a |
| c | a | b |

(32)

| | | |
|---|---|---|
| a | b | c |
| b | c | a |
| b | c | a |

(33)

| | | |
|---|---|---|
| a | b | c |
| b | c | a |
| c | b | a |

(34)

| | | |
|---|---|---|
| a | b | c |
| c | b | a |
| b | c | a |

(35)

| | | |
|---|---|---|
| a | b | c |
| c | b | a |
| c | b | a |

Fig. 4

(1)

| | | |
|---|---|---|
| a | a | b |
| a | b | c |
| b | c | c |

(2)

| | | |
|---|---|---|
| a | a | b |
| a | b | c |
| c | b | c |

(3)

| | | |
|---|---|---|
| a | a | b |
| a | b | c |
| c | c | b |

(4)

| | | |
|---|---|---|
| a | a | b |
| a | c | b |
| b | c | c |

(5)

| | | |
|---|---|---|
| a | a | b |
| a | c | b |
| c | b | c |

(6)

| | | |
|---|---|---|
| a | a | b |
| a | c | b |
| c | c | b |

(7)

| | | |
|---|---|---|
| a | a | b |
| b | a | c |
| b | c | c |

(8)

| | | |
|---|---|---|
| a | a | b |
| b | a | c |
| c | b | c |

(9)

| | | |
|---|---|---|
| a | a | b |
| b | a | c |
| c | c | b |

(10)

| | | |
|---|---|---|
| a | a | b |
| c | a | b |
| b | c | c |

(11)

| | | |
|---|---|---|
| a | a | b |
| c | a | b |
| c | b | c |

(12)

| | | |
|---|---|---|
| a | a | b |
| c | a | b |
| c | c | b |

(13)

| | | |
|---|---|---|
| a | a | b |
| b | c | a |
| b | c | c |

(14)

| | | |
|---|---|---|
| a | a | b |
| b | c | a |
| c | b | c |

(15)

| | | |
|---|---|---|
| a | a | b |
| b | c | a |
| c | c | b |

(16)

| | | |
|---|---|---|
| a | a | b |
| c | b | a |
| b | c | c |

(17)

| | | |
|---|---|---|
| a | a | b |
| c | b | a |
| c | b | c |

(18)

| | | |
|---|---|---|
| a | a | b |
| c | b | a |
| c | c | b |

(19)

| | | |
|---|---|---|
| a | a | b |
| b | c | c |
| a | b | c |

(20)

| | | |
|---|---|---|
| a | a | b |
| b | c | c |
| a | c | b |

(21)

| | | |
|---|---|---|
| a | a | b |
| c | b | c |
| a | b | c |

(22)

| | | |
|---|---|---|
| a | a | b |
| c | b | c |
| a | c | b |

(23)

| | | |
|---|---|---|
| a | a | b |
| c | c | b |
| a | b | c |

(24)

| | | |
|---|---|---|
| a | a | b |
| c | c | b |
| a | c | b |

(25)

| | | |
|---|---|---|
| a | a | b |
| b | c | c |
| b | a | c |

(26)

| | | |
|---|---|---|
| a | a | b |
| b | c | c |
| c | a | b |

(27)

| | | |
|---|---|---|
| a | a | b |
| c | b | c |
| b | a | c |

(28)

| | | |
|---|---|---|
| a | a | b |
| c | b | c |
| c | a | b |

(29)

| | | |
|---|---|---|
| a | a | b |
| c | c | b |
| b | a | c |

(30)

| | | |
|---|---|---|
| a | a | b |
| c | c | b |
| c | a | b |

(31)

| | | |
|---|---|---|
| a | a | b |
| b | c | c |
| b | c | a |

(32)

| | | |
|---|---|---|
| a | a | b |
| b | c | c |
| c | b | a |

(33)

| | | |
|---|---|---|
| a | a | b |
| c | b | c |
| b | c | a |

(34)

| | | |
|---|---|---|
| a | a | b |
| c | b | c |
| c | b | a |

(35)

| | | |
|---|---|---|
| a | a | b |
| c | c | b |
| b | c | a |

(36)

| | | |
|---|---|---|
| a | a | b |
| c | c | b |
| c | b | a |

(37)

| | | |
|---|---|---|
| a | b | a |
| a | b | c |
| b | c | c |

(38)

| | | |
|---|---|---|
| a | b | a |
| a | b | c |
| c | b | c |

(39)

| | | |
|---|---|---|
| a | b | a |
| a | b | c |
| c | c | b |

(40)

| | | |
|---|---|---|
| a | b | a |
| a | c | b |
| b | c | c |

(41)

| | | |
|---|---|---|
| a | b | a |
| a | c | b |
| c | b | c |

(42)

| | | |
|---|---|---|
| a | b | a |
| a | c | b |
| c | c | b |

(43)

| | | |
|---|---|---|
| a | b | a |
| b | a | c |
| b | c | c |

(44)

| | | |
|---|---|---|
| a | b | a |
| b | a | c |
| c | b | c |

(45)

| | | |
|---|---|---|
| a | b | a |
| b | a | c |
| c | c | b |

(46)

| | | |
|---|---|---|
| a | b | a |
| c | a | b |
| b | c | c |

(47)

| | | |
|---|---|---|
| a | b | a |
| c | a | b |
| c | b | c |

(48)

| | | |
|---|---|---|
| a | b | a |
| c | a | b |
| c | c | b |

(49)

| | | |
|---|---|---|
| a | b | a |
| b | c | a |
| b | c | c |

(50)

| | | |
|---|---|---|
| a | b | a |
| b | c | a |
| c | b | c |

(51)

| | | |
|---|---|---|
| a | b | a |
| b | c | a |
| c | b | c |

(52)

| | | |
|---|---|---|
| a | b | a |
| c | b | a |
| b | c | c |

(53)

| | | |
|---|---|---|
| a | b | a |
| c | b | a |
| c | b | c |

(54)

| | | |
|---|---|---|
| a | b | a |
| c | b | a |
| c | c | b |

(55)

| | | |
|---|---|---|
| a | b | a |
| b | c | c |
| a | b | c |

(56)

| | | |
|---|---|---|
| a | b | a |
| b | c | c |
| a | c | b |

(57)

| | | |
|---|---|---|
| a | b | a |
| c | b | c |
| a | b | c |

(58)

| | | |
|---|---|---|
| a | b | a |
| c | b | c |
| a | c | b |

(59)

| | | |
|---|---|---|
| a | b | a |
| c | c | b |
| a | b | c |

(60)

| | | |
|---|---|---|
| a | b | a |
| c | c | b |
| a | c | b |

(61)

| | | |
|---|---|---|
| a | b | a |
| b | c | c |
| b | a | c |

(62)

| | | |
|---|---|---|
| a | b | a |
| b | c | c |
| c | a | b |

(63)

| | | |
|---|---|---|
| a | b | a |
| c | b | c |
| b | a | c |

(64)

| | | |
|---|---|---|
| a | b | a |
| c | b | c |
| c | a | b |

(65)

| | | |
|---|---|---|
| a | b | a |
| c | c | b |
| b | a | c |

(66)

| | | |
|---|---|---|
| a | b | a |
| c | c | b |
| c | a | b |

(67)

| | | |
|---|---|---|
| a | b | a |
| b | c | c |
| b | c | a |

(68)

| | | |
|---|---|---|
| a | b | a |
| b | c | c |
| c | b | a |

(69)

| | | |
|---|---|---|
| a | b | a |
| c | b | c |
| b | c | a |

(70)

| | | |
|---|---|---|
| a | b | a |
| c | b | c |
| c | b | a |

(71)

| | | |
|---|---|---|
| a | b | a |
| c | c | b |
| b | c | a |

(72)

| | | |
|---|---|---|
| a | b | a |
| c | c | b |
| c | b | a |

(73)

| | | |
|---|---|---|
| a | b | c |
| a | a | b |
| b | c | c |

(74)

| | | |
|---|---|---|
| a | b | c |
| a | a | b |
| c | b | c |

(75)

| | | |
|---|---|---|
| a | b | c |
| a | a | b |
| c | c | b |

(76)

| | | |
|---|---|---|
| a | b | c |
| a | a | c |
| b | b | c |

(77)

| | | |
|---|---|---|
| a | b | c |
| a | a | c |
| b | c | b |

(78)

| | | |
|---|---|---|
| a | b | c |
| a | a | c |
| c | b | b |

(79)

| | | |
|---|---|---|
| a | b | c |
| a | b | a |
| b | c | c |

(80)

| | | |
|---|---|---|
| a | b | c |
| a | b | a |
| c | b | c |

(81)

| | | |
|---|---|---|
| a | b | c |
| a | b | a |
| c | c | b |

(82)

| | | |
|---|---|---|
| a | b | c |
| a | c | a |
| b | b | c |

(83)

| | | |
|---|---|---|
| a | b | c |
| a | c | a |
| b | c | b |

(84)

| | | |
|---|---|---|
| a | b | c |
| a | c | a |
| c | b | b |

(85)

| | | |
|---|---|---|
| a | b | b |
| a | b | c |
| a | c | c |

(86)

| | | |
|---|---|---|
| a | b | b |
| a | c | b |
| a | c | c |

(87)

| | | |
|---|---|---|
| a | b | b |
| a | c | c |
| a | b | c |

(88)

| | | |
|---|---|---|
| a | b | b |
| a | c | c |
| a | c | b |

(89)

| | | |
|---|---|---|
| a | b | c |
| a | b | b |
| a | c | c |

(90)

| | | |
|---|---|---|
| a | b | c |
| a | c | c |
| a | b | b |

(91)

| | | |
|---|---|---|
| a | b | b |
| a | b | c |
| c | a | c |

(92)

| | | |
|---|---|---|
| a | b | b |
| a | c | b |
| c | a | c |

(93)

| | | |
|---|---|---|
| a | b | b |
| a | c | c |
| b | a | c |

(94)

| | | |
|---|---|---|
| a | b | b |
| a | c | c |
| c | a | b |

(95)

| | | |
|---|---|---|
| a | b | c |
| a | b | b |
| c | a | c |

(96)

| | | |
|---|---|---|
| a | b | c |
| a | c | c |
| b | a | b |

(97)

| | | |
|---|---|---|
| a | b | b |
| a | b | c |
| c | c | a |

(98)

| | | |
|---|---|---|
| a | b | b |
| a | c | b |
| c | c | a |

(99)

| | | |
|---|---|---|
| a | b | b |
| a | c | c |
| b | c | a |

(100)

| | | |
|---|---|---|
| a | b | b |
| a | c | c |
| c | b | a |

(101)

| | | |
|---|---|---|
| a | b | c |
| a | b | b |
| c | c | a |

(102)

| | | |
|---|---|---|
| a | b | c |
| a | c | c |
| b | b | a |

(103)

| | | |
|---|---|---|
| a | b | c |
| b | a | a |
| b | c | c |

(104)

| | | |
|---|---|---|
| a | b | c |
| b | a | a |
| c | b | c |

(105)

| | | |
|---|---|---|
| a | b | c |
| b | a | a |
| c | c | b |

(106)

| | | |
|---|---|---|
| a | b | c |
| c | a | a |
| b | b | c |

(107)

| | | |
|---|---|---|
| a | b | c |
| c | a | a |
| b | c | b |

(108)

| | | |
|---|---|---|
| a | b | c |
| c | a | a |
| c | b | b |

(109)

| | | |
|---|---|---|
| a | b | b |
| b | a | c |
| a | c | c |

(110)

| | | |
|---|---|---|
| a | b | b |
| c | a | b |
| a | c | c |

(111)

| | | |
|---|---|---|
| a | b | b |
| c | a | c |
| a | b | c |

(112)

| | | |
|---|---|---|
| a | b | b |
| c | a | c |
| a | c | b |

(113)

| | | |
|---|---|---|
| a | b | c |
| b | a | b |
| a | c | c |

(114)

| | | |
|---|---|---|
| a | b | c |
| c | a | c |
| a | b | b |

(115)

| | | |
|---|---|---|
| a | b | b |
| b | a | c |
| c | a | c |

(116)

| | | |
|---|---|---|
| a | b | b |
| c | a | b |
| c | a | c |

(117)

| | | |
|---|---|---|
| a | b | b |
| c | a | c |
| b | a | c |

(118)

| | | |
|---|---|---|
| a | b | b |
| c | a | c |
| c | a | b |

(119)

| | | |
|---|---|---|
| a | b | c |
| b | a | b |
| c | a | c |

(120)

| | | |
|---|---|---|
| a | b | c |
| c | a | c |
| b | a | b |

(121)

| | | |
|---|---|---|
| a | b | b |
| b | a | c |
| c | c | a |

(122)

| | | |
|---|---|---|
| a | b | b |
| c | a | b |
| c | c | a |

(123)

| | | |
|---|---|---|
| a | b | b |
| c | a | c |
| b | c | a |

(124)

| | | |
|---|---|---|
| a | b | b |
| c | a | c |
| c | b | a |

(125)

| | | |
|---|---|---|
| a | b | c |
| b | a | b |
| c | c | a |

(126)

| | | |
|---|---|---|
| a | b | c |
| c | a | c |
| b | b | a |

(127)

| | | |
|---|---|---|
| a | b | b |
| b | c | a |
| a | c | c |

(128)

| | | |
|---|---|---|
| a | b | b |
| c | b | a |
| a | c | c |

(129)

| | | |
|---|---|---|
| a | b | b |
| c | c | a |
| a | b | c |

(130)

| | | |
|---|---|---|
| a | b | b |
| c | c | a |
| a | c | b |

(131)

| | | |
|---|---|---|
| a | b | c |
| b | b | a |
| a | c | c |

(132)

| | | |
|---|---|---|
| a | b | c |
| c | c | a |
| a | b | b |

(133)

| | | |
|---|---|---|
| a | b | b |
| b | c | a |
| c | a | c |

(134)

| | | |
|---|---|---|
| a | b | b |
| c | b | a |
| c | a | c |

(135)

| | | |
|---|---|---|
| a | b | b |
| c | c | a |
| b | a | c |

(136)

| | | |
|---|---|---|
| a | b | b |
| c | c | a |
| c | a | b |

(137)

| | | |
|---|---|---|
| a | b | c |
| b | b | a |
| c | a | c |

(138)

| | | |
|---|---|---|
| a | b | c |
| c | c | a |
| b | a | b |

(139)

| | | |
|---|---|---|
| a | b | b |
| b | c | a |
| c | c | a |

(140)

| | | |
|---|---|---|
| a | b | b |
| c | b | a |
| c | c | a |

(141)

| | | |
|---|---|---|
| a | b | b |
| c | c | a |
| b | c | a |

(142)

| | | |
|---|---|---|
| a | b | b |
| c | c | a |
| c | b | a |

(143)

| | | |
|---|---|---|
| a | b | c |
| b | b | a |
| c | c | a |

(144)

| | | |
|---|---|---|
| a | b | c |
| c | c | a |
| b | b | a |

(145)

| | | |
|---|---|---|
| a | b | c |
| b | b | c |
| a | a | c |

(146)

| | | |
|---|---|---|
| a | b | c |
| b | c | b |
| a | a | c |

(147)

| | | |
|---|---|---|
| a | b | c |
| b | c | c |
| a | a | b |

(148)

| | | |
|---|---|---|
| a | b | c |
| c | b | b |
| a | a | c |

(149)

| | | |
|---|---|---|
| a | b | c |
| c | b | c |
| a | a | b |

(150)

| | | |
|---|---|---|
| a | b | c |
| c | c | b |
| a | a | b |

(151)

| | | |
|---|---|---|
| a | b | c |
| b | b | c |
| a | c | a |

(152)

| | | |
|---|---|---|
| a | b | c |
| b | c | b |
| a | c | a |

(153)

| | | |
|---|---|---|
| a | b | c |
| b | c | c |
| a | b | a |

(154)

| | | |
|---|---|---|
| a | b | c |
| c | b | b |
| a | c | a |

(155)

| | | |
|---|---|---|
| a | b | c |
| c | b | c |
| a | b | a |

(156)

| | | |
|---|---|---|
| a | b | c |
| c | c | b |
| a | b | a |

(157)

| | | |
|---|---|---|
| a | b | c |
| b | b | c |
| c | a | a |

(158)

| | | |
|---|---|---|
| a | b | c |
| b | c | b |
| c | a | a |

(159)

| | | |
|---|---|---|
| a | b | c |
| b | c | c |
| b | a | a |

(160)

| | | |
|---|---|---|
| a | b | c |
| c | b | b |
| c | a | a |

(161)

| | | |
|---|---|---|
| a | b | c |
| c | b | c |
| b | a | a |

(162)

| | | |
|---|---|---|
| a | b | c |
| c | c | b |
| b | a | a |

Fig. 5

(1)

| | | |
|---|---|---|
| a | a | b |
| a | c | c |
| b | b | c |

(2)

| | | |
|---|---|---|
| a | a | b |
| a | c | c |
| b | c | b |

(3)

| | | |
|---|---|---|
| a | a | b |
| a | c | c |
| c | b | b |

(4)

| | | |
|---|---|---|
| a | a | b |
| c | a | c |
| b | b | c |

(5)

| | | |
|---|---|---|
| a | a | b |
| c | a | c |
| b | c | b |

(6)

| | | |
|---|---|---|
| a | a | b |
| c | a | c |
| c | b | b |

(7)

| | | |
|---|---|---|
| a | a | b |
| c | c | a |
| b | b | c |

(8)

| | | |
|---|---|---|
| a | a | b |
| c | c | a |
| b | c | b |

(9)

| | | |
|---|---|---|
| a | a | b |
| c | c | a |
| c | b | b |

(10)

| | | |
|---|---|---|
| a | a | b |
| b | b | c |
| a | c | c |

(11)

| | | |
|---|---|---|
| a | a | b |
| b | c | b |
| a | c | c |

(12)

| | | |
|---|---|---|
| a | a | b |
| c | b | b |
| a | c | c |

(13)

| | | |
|---|---|---|
| a | a | b |
| b | b | c |
| c | a | c |

(14)

| | | |
|---|---|---|
| a | a | b |
| b | c | b |
| c | a | c |

(15)

| | | |
|---|---|---|
| a | a | b |
| c | b | b |
| c | a | c |

(16)

| | | |
|---|---|---|
| a | a | b |
| b | b | c |
| c | c | a |

(17)

| | | |
|---|---|---|
| a | a | b |
| b | c | b |
| c | c | a |

(18)

| | | |
|---|---|---|
| a | a | b |
| c | b | b |
| c | c | a |

(19)

| | | |
|---|---|---|
| a | b | a |
| a | c | c |
| b | b | c |

(20)

| | | |
|---|---|---|
| a | b | a |
| a | c | c |
| b | c | b |

(21)

| | | |
|---|---|---|
| a | b | a |
| a | c | c |
| c | b | b |

(22)

| | | |
|---|---|---|
| a | b | a |
| c | a | c |
| b | b | c |

(23)

| | | |
|---|---|---|
| a | b | a |
| c | a | c |
| b | c | b |

(24)

| | | |
|---|---|---|
| a | b | a |
| c | a | c |
| c | b | b |

(25)

| | | |
|---|---|---|
| a | b | a |
| c | c | a |
| b | b | c |

(26)

| | | |
|---|---|---|
| a | b | a |
| c | c | a |
| b | c | b |

(27)

| | | |
|---|---|---|
| a | b | a |
| c | c | a |
| c | b | b |

(28)

| | | |
|---|---|---|
| a | b | a |
| b | b | c |
| a | c | c |

(29)

| | | |
|---|---|---|
| a | b | a |
| b | c | b |
| a | c | c |

(30)

| | | |
|---|---|---|
| a | b | a |
| c | b | b |
| a | c | c |

(31)

| | | |
|---|---|---|
| a | b | a |
| b | b | c |
| c | a | c |

(32)

| | | |
|---|---|---|
| a | b | a |
| b | c | b |
| c | a | c |

(33)

| | | |
|---|---|---|
| a | b | a |
| c | b | b |
| c | a | c |

(34)

| | | |
|---|---|---|
| a | b | a |
| b | b | c |
| c | c | a |

(35)

| | | |
|---|---|---|
| a | b | a |
| b | c | b |
| c | c | a |

(36)

| | | |
|---|---|---|
| a | b | a |
| c | b | b |
| c | c | a |

(37)

| | | |
|---|---|---|
| a | b | b |
| a | a | c |
| b | c | c |

(38)

| | | |
|---|---|---|
| a | b | b |
| a | a | c |
| c | b | c |

(39)

| | | |
|---|---|---|
| a | b | b |
| a | a | c |
| c | c | b |

(40)

| | | |
|---|---|---|
| a | b | b |
| a | c | a |
| b | c | c |

(41)

| | | |
|---|---|---|
| a | b | b |
| a | c | a |
| c | b | c |

(42)

| | | |
|---|---|---|
| a | b | b |
| a | c | a |
| c | c | b |

(43)

| | | |
|---|---|---|
| a | b | b |
| c | a | a |
| b | c | c |

(44)

| | | |
|---|---|---|
| a | b | b |
| c | a | a |
| c | b | c |

(45)

| | | |
|---|---|---|
| a | b | b |
| c | a | a |
| c | c | b |

(46)

| | | |
|---|---|---|
| a | b | b |
| b | c | c |
| a | a | c |

(47)

| | | |
|---|---|---|
| a | b | b |
| c | b | c |
| a | a | c |

(48)

| | | |
|---|---|---|
| a | b | b |
| c | c | b |
| a | a | c |

(49)

| | | |
|---|---|---|
| a | b | b |
| b | c | c |
| a | c | a |

(50)

| | | |
|---|---|---|
| a | b | b |
| c | b | c |
| a | c | a |

(51)

| | | |
|---|---|---|
| a | b | b |
| c | c | b |
| a | c | a |

(52)

| | | |
|---|---|---|
| a | b | b |
| b | c | c |
| c | a | a |

(53)

| | | |
|---|---|---|
| a | b | b |
| c | b | c |
| c | a | a |

(54)

| | | |
|---|---|---|
| a | b | b |
| c | c | b |
| c | a | a |

Fig. 6

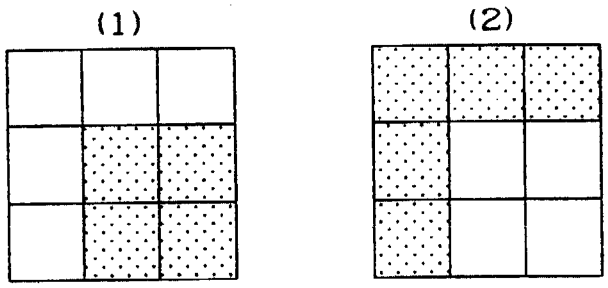

Fig. 7

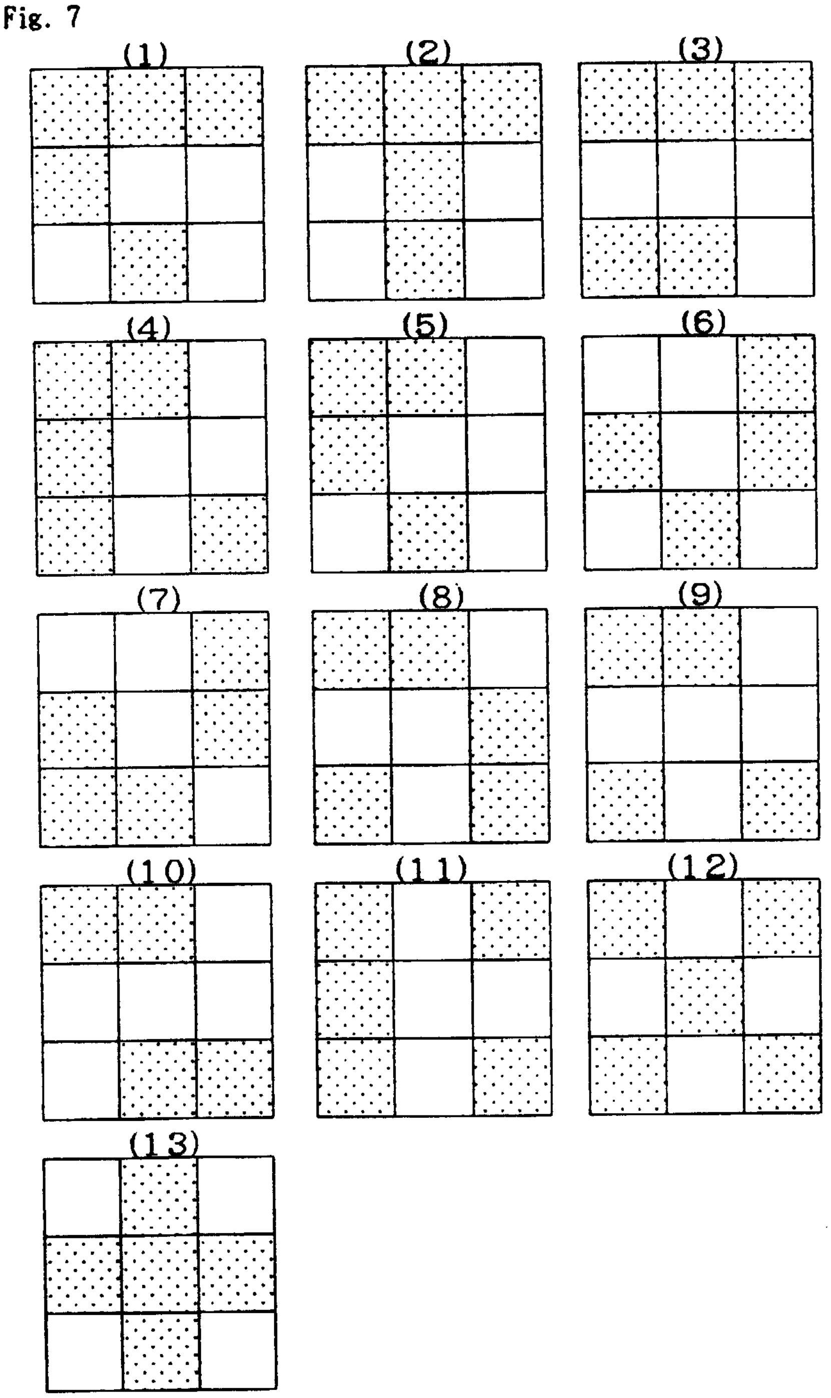

Fig. 8

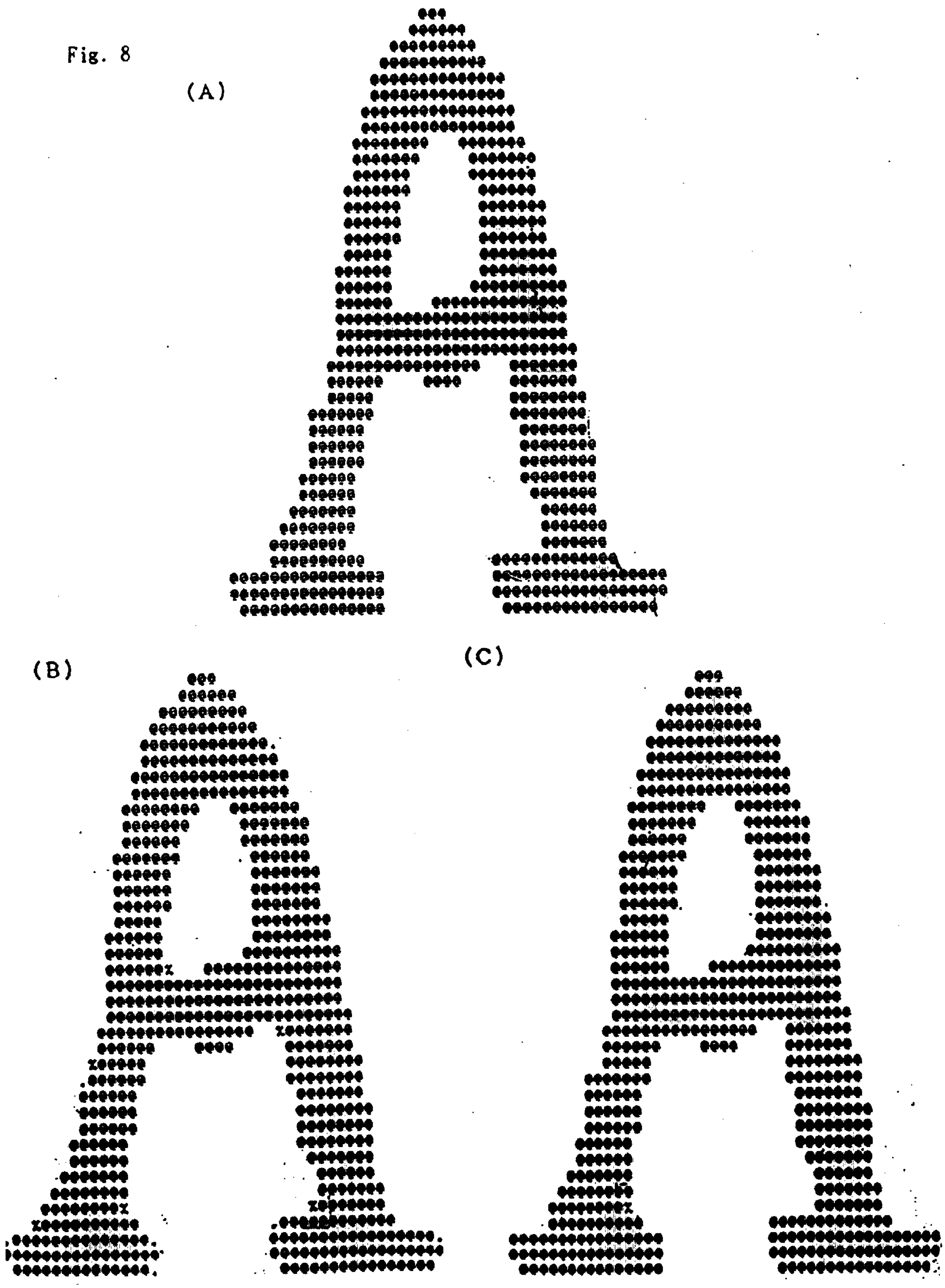

Fig. 9

(A)

(B)

(C)

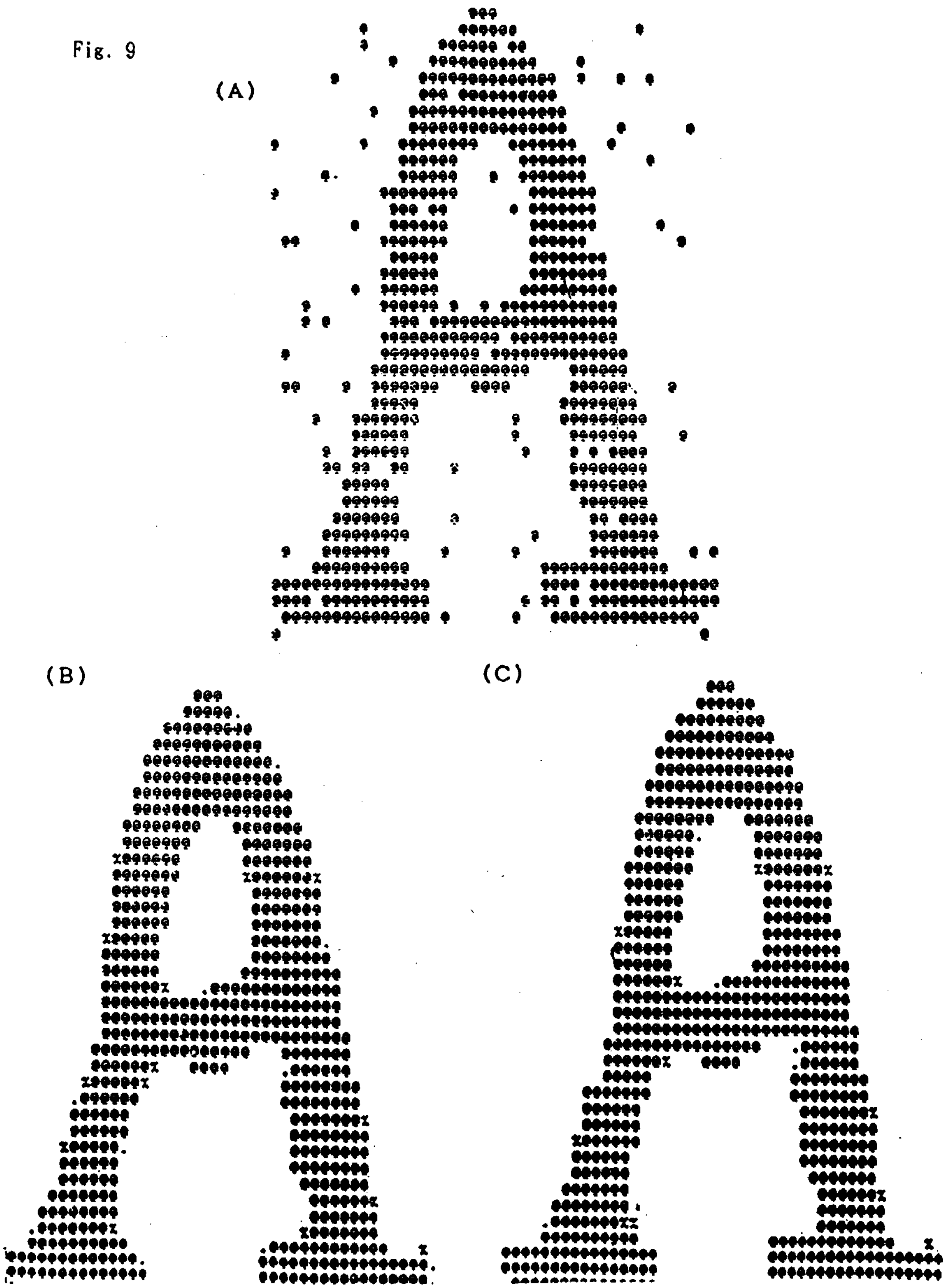

Fig. 10

(A)

(B)

(C)

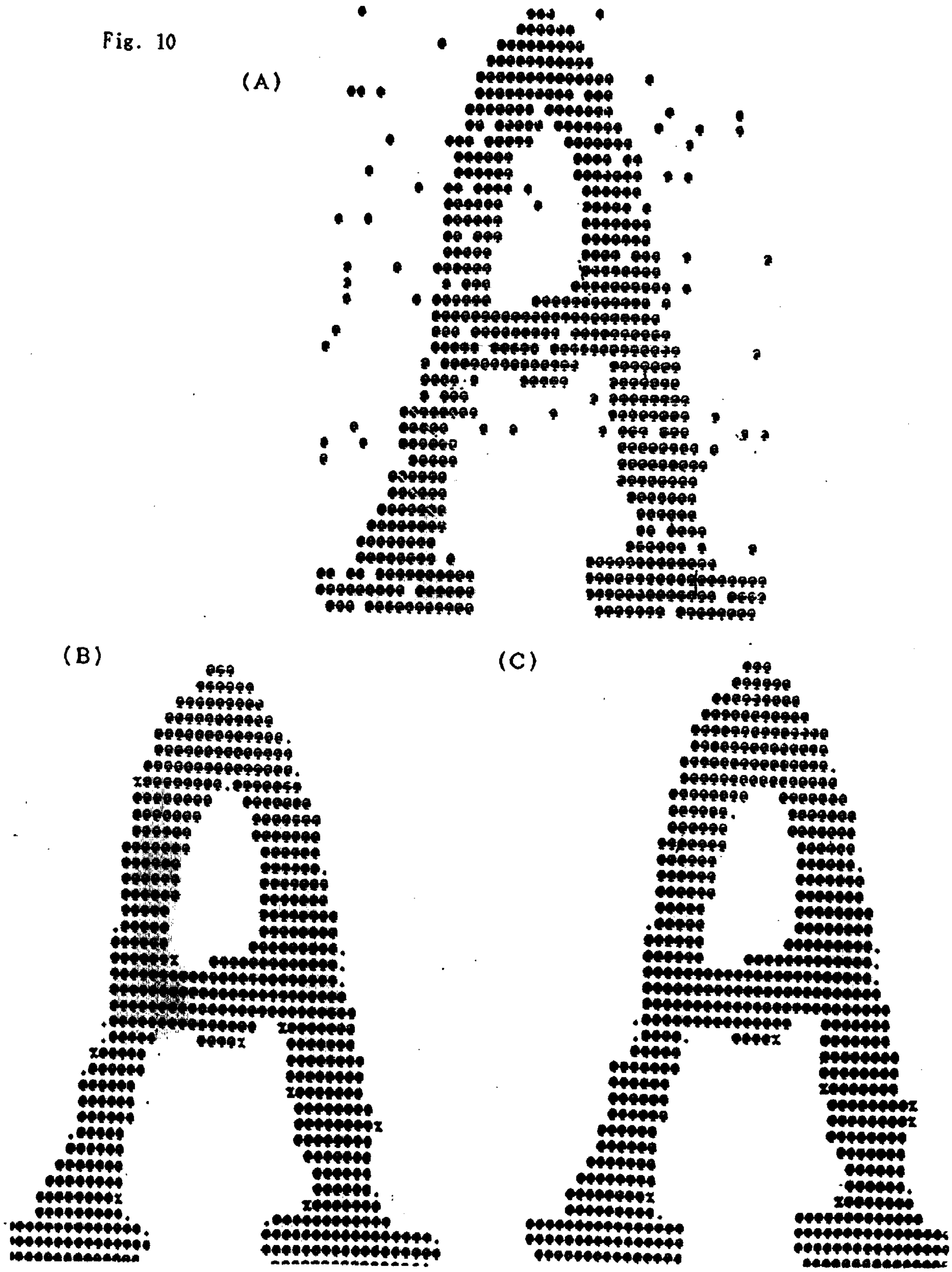

Fig. 11

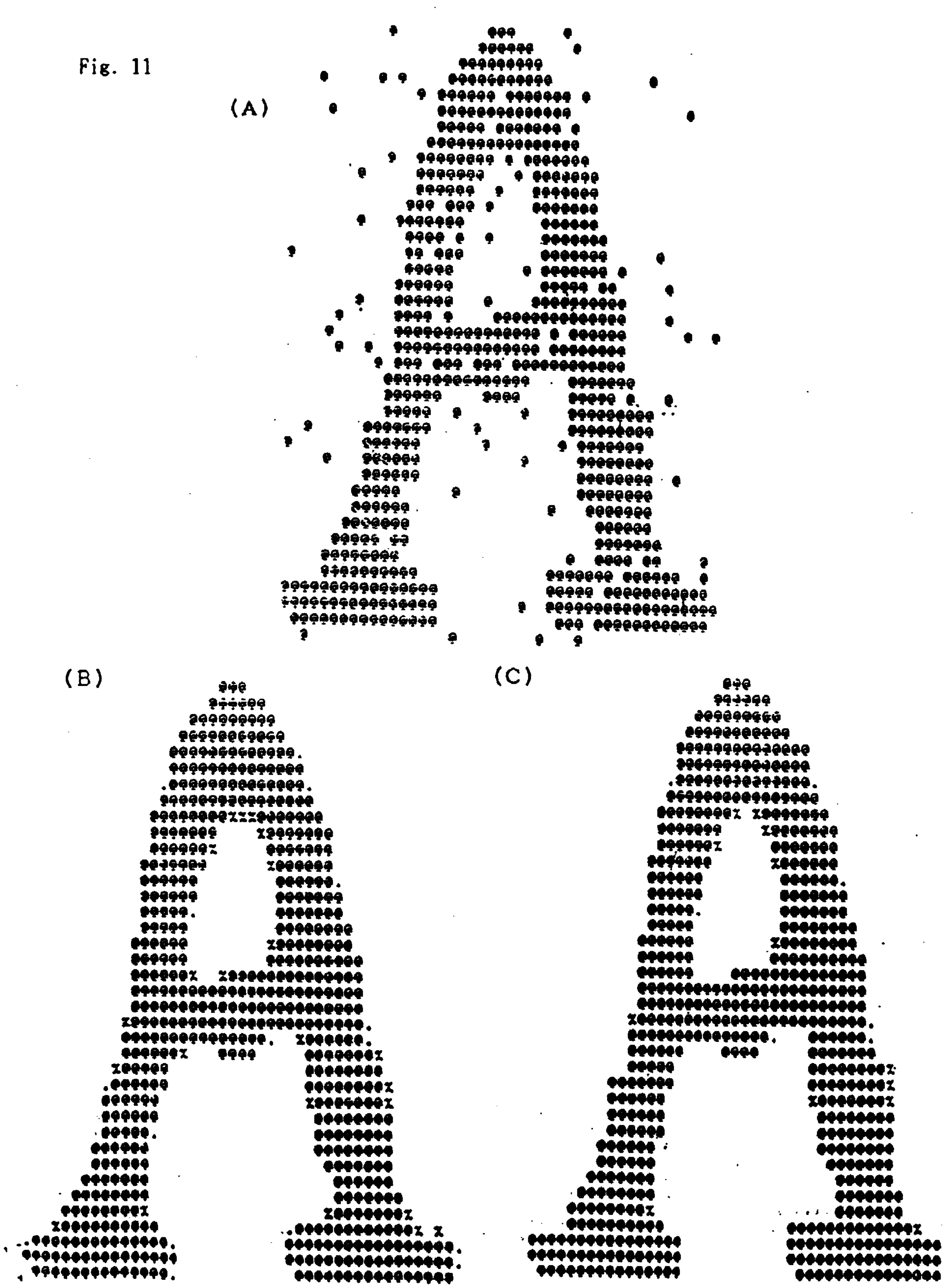

Fig. 12

(A)

(B)

(C)

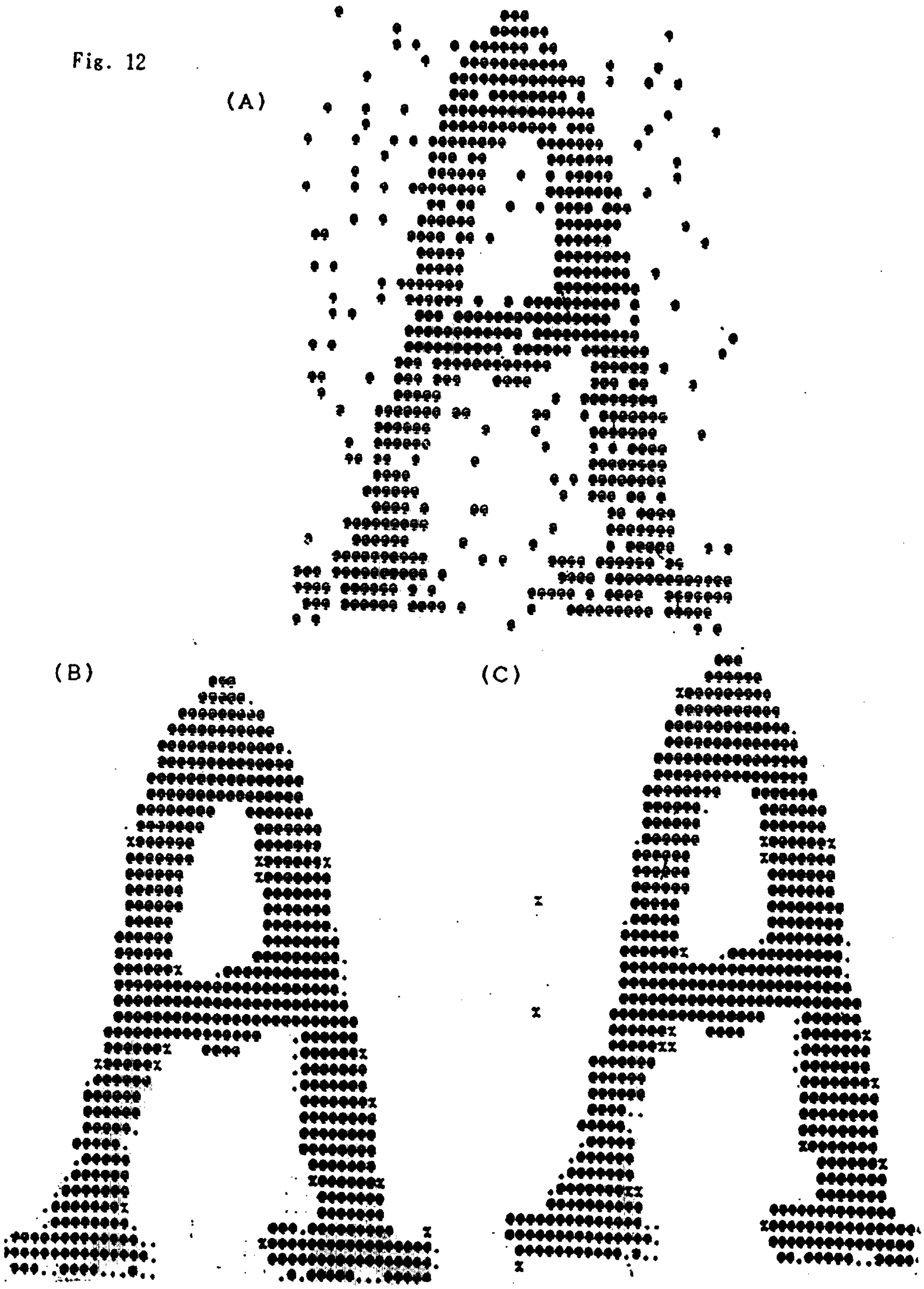

Fig. 13

(A)

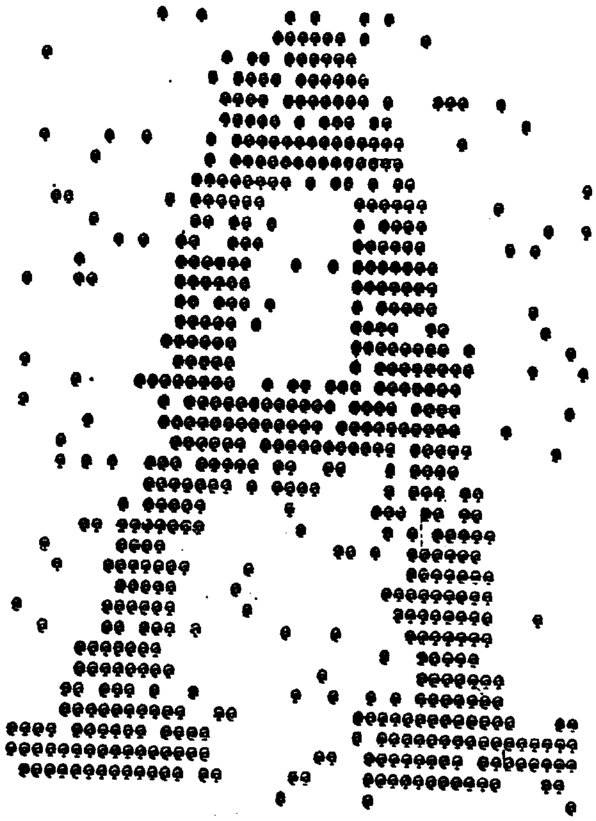

(B)

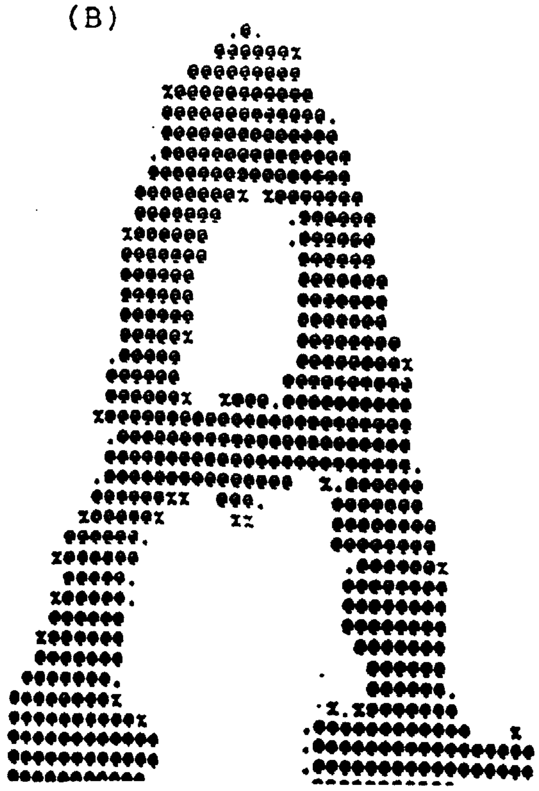

(C)

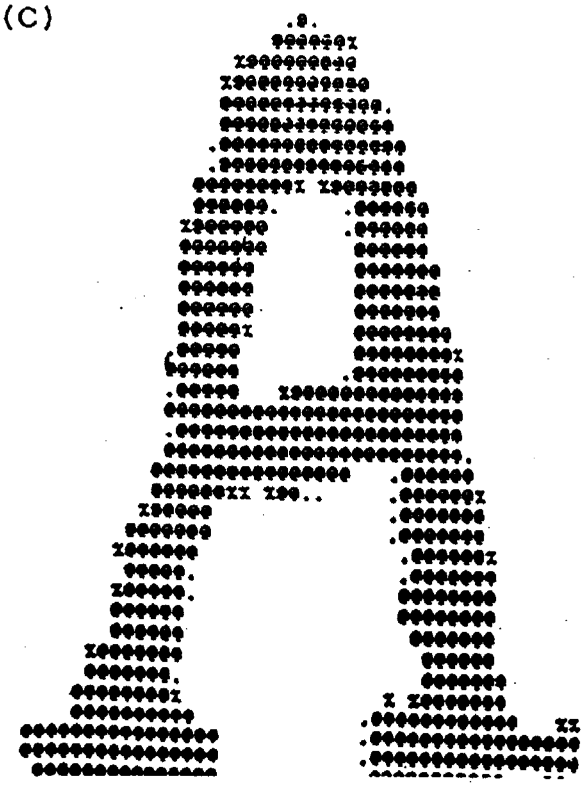

Fig. 14

| | | |
|---|---|---|
| a | b | c |
| d | e | f |
| g | h | i |

Fig. 15

| | | | | |
|---|---|---|---|---|
| a | b | c | d | e |
| f | g | h | i | j |
| k | l | m | n | o |
| p | q | r | s | t |
| u | v | w | x | y |

Fig. 16

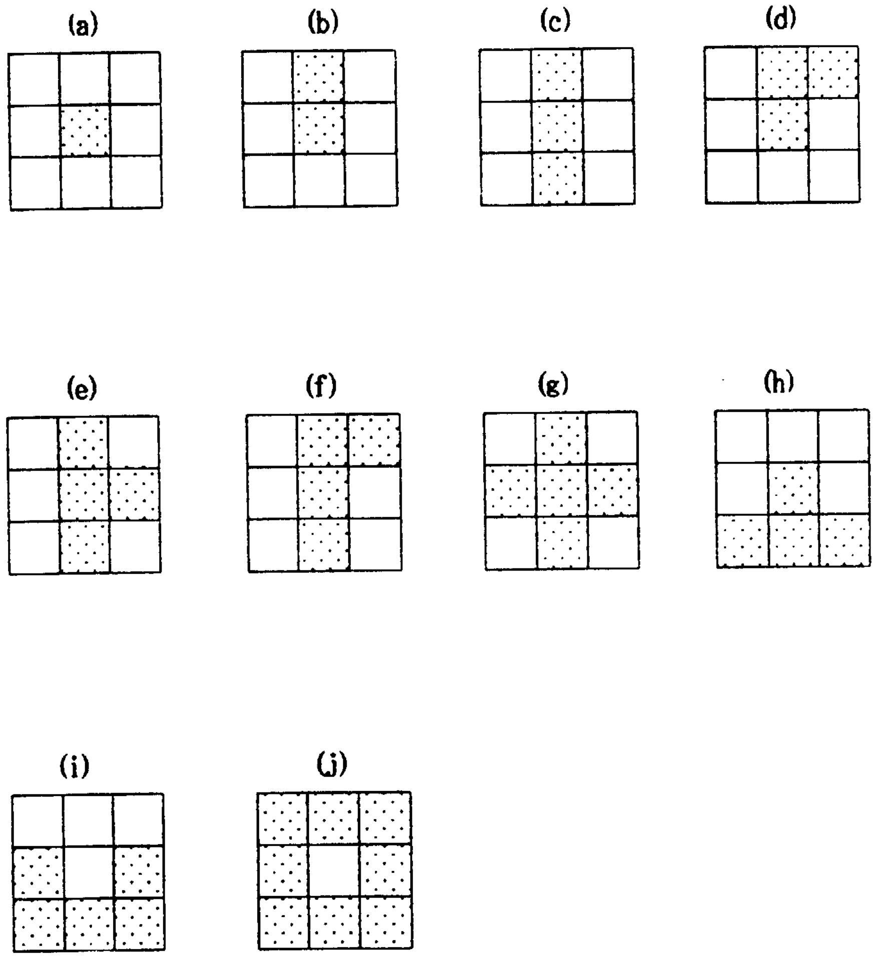

Fig. 17